(19) Europäisches Patentamt
European Patent Office
Office européen des brevets

(11) **EP 4 671 406 A1**

(12) **EUROPEAN PATENT APPLICATION**

(43) Date of publication:
**31.12.2025 Bulletin 2026/01**

(21) Application number: **24185086.6**

(22) Date of filing: **27.06.2024**

(51) International Patent Classification (IPC):
*C23C 14/04* (2006.01)  *C23C 14/22* (2006.01)
*C23C 14/52* (2006.01)  *C23C 14/54* (2006.01)
*H01L 21/308* (2006.01)  *H05B 33/10* (2006.01)
*H10K 71/16* (2023.01)  *G03F 9/00* (2006.01)
*B82Y 40/00* (2011.01)

(52) Cooperative Patent Classification (CPC):
**C23C 14/044; B82Y 40/00; C23C 14/225;
C23C 14/52; C23C 14/542;** H10K 71/166

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **ETH Zurich
8092 Zurich (CH)**

(72) Inventors:
• **SHIH, Chih-Jen
8044 Zürich (CH)**
• **OH, Jiwoo
8046 Zürich (CH)**
• **ZENG, Shuangshuang
Wuhan, 430074 (CN)**

(54) **THREE-DIMENSIONAL DEPOSITION OF A DEPOSITION STRUCTURE ON A SUBSTRATE**

(57)     A method of producing a deposition structure (1) on a substrate (2) comprises the steps of i) providing at least one depositor (3) for depositing at least one material (6), ii) providing at least one mask (4) comprising a plurality of apertures (5, 5a, ...), iii) providing at least one substrate (2), and iv) depositing at least one material (6) from the depositor (3). Part of the material (6) passes through the apertures (5, 5a, ...) of the mask (4) and is deposited on a surface (7) of the substrate (2), whereby at least one deposition structure (1) is formed on the surface (7) of the substrate (2). At least one tilting angle ($\varphi$) between i) the substrate (2) and/or the mask (4) and ii) the depositor (3) is at least temporarily changed before and/or during the deposition of the material (6). Additionally or alternatively, at least one rotating angle ($\theta$) between i) the substrate (2) and/or the mask (4) and ii) the depositor (3) is at least temporarily changed before and/or during the deposition of the material (6).

FIG. 1a

**Description**

TECHNICAL FIELD

The present invention relates to a method of producing a deposition structure on a substrate according to claim 1, to a computer-implemented method of determining operation parameters for producing such a deposition structure according to claim 12, to a non-transient computer readable medium that causes a processor to perform these methods according to claim 13, to a depositor arrangement according to claim 14, and to the use of a deposition structure as a display or metasurface according to claim 15.

PRIOR ART

The development of nanotechnology has greatly advanced the nanopatterning techniques, leading to the fabrication of intricate and innovative 3D nanoscale structures for electronics[1], optics[2], bioengineering[3] and sensing[4]. These state-of-the-art nanopatterning techniques can be categorized into two major branches: top-down and bottom-up approaches. The former includes electron beam lithography, deep ultraviolet lithography, extreme ultraviolet lithography, scanning probe lithography and nanoimprint lithography. The latter encompasses structural DNA nanotechnology and block copolymer self-assembly. Of existing nanopatterning techniques, most approaches cannot pattern the material of interest directly and rely on templating the patterns on the resists/polymers, followed by transferring the patterns by means of material deposition or etching. Beyond that, these approaches often necessitate various resists and solvent processing, limiting the material compatibility and complicating the process. A technique allowing for direct nanopatterning of material of interest is highly desired in terms of high efficiency, low cost, minimal environmental impact and broad applicability.

Several alternative methods have emerged for direct patterning at the nanoscale, such as nanostencil lithography (NSL)[5,6], nanotransfer printing[7,8] and charged aerosol jets[9]. NSL can achieve direct patterning of metal dots less than 15 nm in diameter and lines 15-20 nm wide[10], but it has finite pattern design and struggles with complex structures. Nanotransfer printing uses adhesive transfer of patterned nanostructures from a stamp to a substrate, but it mainly works with metals and operates in a restricted range of processing conditions. Charged aerosol jets can realize direct 3D printing of metal nanostructures with flexible geometry, but its operation demands nanoparticles for the generation of charged aerosols. Additionally, nanopatterning of multiple materials remains challenging due to the need for multiple patterning of different materials with good alignment accuracy.

SUMMARY OF THE INVENTION

It is an object of the present invention to provide a method of producing a deposition structure on a substrate of materials of interest with high efficiency and in a simplified manner.

This object is achieved with a method according to claim 1. That is, a method of producing a deposition structure on a substrate is provided, wherein the method comprises the steps of i) providing at least one depositor for depositing at least one material, ii) providing at least one mask comprising a plurality of apertures, iii) providing at least one substrate, and iv) depositing at least one material from the depositor. Part of the material passes through the apertures of the mask and is deposited on the surface of the substrate, whereby at least one deposition structure is formed on the surface of the substrate. At least one tilting angle between i) the substrate and/or the mask and ii) the depositor is at least temporarily changed before and/or during the deposition of the material. Additionally or alternatively, at least one rotating angle between i) the substrate and/or the mask and ii) the depositor is at least temporarily changed before and/or during the deposition of the material.

The depositor preferably comprises the material to be deposited, herein sometimes referred to as source material.

The depositor is preferably configured to deposit the material on the substrate by generating beams of material that reach the surface of the substrate.

Various kinds of depositors are conceivable that are well-known in the art. For instance, the depositor can be a vacuum depositor and/or a vapor depositor, and wherein the material is deposited by vacuum deposition and/or vapor deposition. To this end it is particularly preferred that the depositor is a physical vapor depositor and that the material is deposited by physical vapor deposition. An example of which is electron-beam physical vapor deposition, wherein the material to be deposited is heated to a high vapor pressure by electron bombardment in vacuum and is transported by diffusion to be deposited by condensation on the surface of the substrate. Another example of which is cathodic arc deposition, wherein a high-power electric arc discharged at the source material blasts away part of the source material into highly ionized vapor to be deposited onto the surface of the substrate. Another example is thermal evaporative deposition, wherein the material to be deposited is heated to a high vapor pressure by electrical resistance heating in vacuum. Another example is laser ablation deposition, wherein a laser ablates the source material into a vapor. Another example is thermal laser deposition, wherein a laser evaporates the source material which then condenses upon the surface of the substrate. Again another example is sputter deposition, wherein a glow plasma discharge bombards the source material sputtering part of the source material away as a vapor for subsequent deposition on the surface of the substrate, etc.

The mask preferably serves the purpose of physically blocking part of the material, in particular part of the beams of material that are generated by the depositor. As a result, only parts of the material, in particular parts of the beams of material, that pass through the apertures of the mask will reach the surface of the substrate to form the deposition structure.

The mask therefore lies between the depositor and the substrate. In other words, with respect to the beams of material, the mask is arranged after the depositor, and the substrate in turn is arranged after the mask.

The tilting angle between the substrate and the depositor is preferably enclosed by the surface of the substrate onto which the material is deposited and a surface of the depositor facing the mask.

The tilting angle between the mask and the depositor is preferably enclosed by a surface of the mask that faces the surface of the substrate onto which the material is deposited and a surface of the depositor facing the mask.

The rotating angle of the substrate preferably is the angle about which the surface of the substrate onto which the material is deposited is rotated with respect to the depositor, in particular with respect to a surface of the depositor that faces the mask.

The rotating angle of the mask preferably is the angle about which a surface of the mask that faces the surface of the substrate onto which the material is deposited and a surface of the depositor facing the mask.

The substrate and/or the mask is preferably at least temporarily rotated and/or tilted such, that the deposition structure comprises or consists of material being deposited on the surface at a given position on the surface that is provided from two or more beams of material passing through at least one aperture of the mask at different moments in time.

Additionally or alternatively, the substrate and/or the mask is preferably at least temporarily rotated and/or tilted such, that the deposition structure comprises or consists of material being deposited on the surface at a given position on the surface that is spatially displaced with respect to a reference-incidence position of said material normal to the surface of the substrate.

Additionally or alternatively, the substrate and/or the mask is preferably at least temporarily rotated and tilted such, that two or more beams of material are interfering with one another.

Additionally or alternatively, the substrate and/or the mask is preferably at least temporarily rotated and tilted such, that an amount of material deposited at specific positions on the surface of the substrate is modulated.

The two or more beams of material being interfering with one another means that said two or more beams of material at least partially overlap on their path to the surface of the substrate. Said interference or overlap of the beams of material can also be seen as a superposition of the beams of material.

As a consequence, the material being deposited from such interfering beams of materials enable a modulation of the amount of material being deposited at specific positions on the surface of the substrate. For instance, the beams of material can be interfering in a constructive manner, wherein the amount of material deposited at the position of incidence of said beams on the surface of the substrate has a higher density as compared to the position of incidence of beams of material that are interfering in a destructive manner.

In other words, the beams of material can be interfering with one another so as to form positions on the surface of the substrate wherein the deposition structure has a high amount or a high density of deposited material, as well as positions on the surface of the substrate wherein the deposition structure has a low amount or low density of deposited material. It is even conceivable that the interference of the beams of material is such that vacant positions are created on the surface of the substrate, *i.e.* positions that do not comprise any deposited material.

This allows the generation of a deposition structure in a variety of patterns. For example, the deposition structure can be deposited in such a way that an interference pattern is formed, for instance a Moiré pattern.

To this end, the deposition structure can be formed from two or more interfering beams that pass through the same aperture and/or through two or more apertures.

For instance, the deposition structure can be formed from one or more beams of material that are offset/deviating/displaced with respect to a (theoretical) incidence position being normal to the surface of the substrate irrespective of whether or not they pass through the same or different apertures. For instance, an interference such as a bullseye Moiré pattern (see also further below) can be formed from interfering beams of material that pass through the same aperture. In this case, it is preferred that at least two material beams are used that pass through said same aperture, and wherein said two beams are distinguished by different tilting and/or rotating angles.

It should be noted that said Moiré interference is understood a kind of "mechanical" interference rather than "optical" interference, without involving a "phase difference" or the like. An example is as follows. The location of 'pale' and 'dark' parts of Moiré pattern depends on the periodicity and angle between the lines/stripes constituting the pattern. Where two lines (either straight or curved) overlap, the periodicity of overlapped pattern is the same as the original periodicity, which makes the part looks pale or lighter. The parts between two overlapping points are darker as the periodicity is smaller than the original periodicity.

Additionally or alternatively, a deposition structure can be formed that comprises or consists of material being deposited on the surface at a given position on the surface that is spatially displaced with respect to a reference-incidence position of said material normal to the surface of the substrate. The spatial displacement of the deposited material can be seen as an offset or deviation from its actual deposition position as compared to said reference position. The reference-incidence position corresponds to a (theoretical) reference position the material would be deposited on in the event that the substrate is not rotated and/or not tilted before and/or during the deposition of the material and/or in the event that the beams of material are not interfering with one another.

To this end it is preferred that the material is deposited such that the beams of material reach the surface of the substrate under an angle of incidence, and wherein said angle of incidence is preferably different from 90° with respect to the surface of the substrate. In other words, the beams of material preferably do not reach the surface of the substrate perpendicularly. Again in other words, an angle between the beams of material and a surface normal to the surface of the substrate is preferably unequal to zero.

The substrate and/or the mask is preferably at least temporarily rotated while being tilted during the deposition of the material.

Additionally or alternatively, the tilting angle can be changed or kept constant during the deposition.

Additionally or alternatively, the rotating angle can be changed or kept constant during the deposition.

The rotating angle and the tilting angle can be the same or different from one another. Various rotating angles are conceivable. In fact, the rotating angle preferably is in the range of 0° to 360°, $i.e.$ $\theta = 360° \times n + \theta$ (°), $0 \le \theta < 360°$. '$\theta$' in degree has periodicity of 360 degrees, but conventionally, $\theta$ ranges from 0 to 360°. Various tilting angles are conceivable. In fact, the tilting angle preferably is between 0° and 90°, $i.e.$ $0 \le \varphi < 90°$.

In case of depositions where the substrate is rotated during the deposition, it is preferred that a rotational speed of the substrate (deg/min) is set appropriately such that mass transport of the beams of material through the apertures of the mask are not limited by an angular speed of the aperture. In other words, it is preferred that a mass transport is faster than the rotational speed. Otherwise, there is the risk that a small amount or no material passes through the aperture.

The substrate is preferably rotated about a rotation axis that runs centrally through the substrate. Additionally or alternatively, the mask is preferably rotated about a rotation axis that runs centrally through the mask. Additionally or alternatively, the substrate is preferably tilted about a tilting axis that runs centrally through the substrate. Additionally or alternatively, the mask is preferably tilted about a tilting axis that runs centrally through the mask. The rotation axis and the tilting axis preferably run parallel to one another.

That is, the rotation axis about which the substrate can be rotated preferably runs parallel to the rotation axis about which the mask can be rotated. Additionally or alternatively, the tilting axis about which the substrate can be tilted preferably runs parallel to the tilting axis about which the mask can be tilted. Additionally or alternatively, the rotation axis about which the substrate can be rotated preferably runs parallel to the tilting axis about which the substrate can be tilted. Additionally or alternatively, the rotation axis about which the mask can be rotated preferably runs parallel to the tilting axis about which the mask can be tilted. It is furthermore preferred that a rotation and a tilting of the substrate and the mask are carried out simultaneously and in particular in a same way, $i.e.$ the substrate preferably rotates about a rotating angle that corresponds to the rotating angle of the mask and the substrate tilts about a tilting angle that corresponds to the tilting angle of the mask. In other words, the mask and the substrate are preferably rotated and/or tilted in synchrony. However, it is likewise conceivable that only one of them, $i.e.$ that either the mask or the substrate, is rotated and/or tilted.

The depositor is preferably kept stationary during deposition. The depositor being kept stationary preferably means that the depositor is neither rotated nor tilted during deposition.

The mask and the substrate are preferably arranged at a distance from one another. The distance is preferably the distance between the surface of the substrate onto which the material is deposited and a surface of the mask facing said surface of the substrate. The distance is preferably kept constant during the deposition. Various distances are conceivable. For instance, said distance can be in a range of 0.05 micrometer to 20 micrometers, such as 0.1 micrometer to 10 micrometers, for instance 0.1 to 2.5 micrometers.

In particular, the mask preferably comprises a membrane comprising the apertures, and wherein a surface of said membrane comprising the apertures faces the surface of the substrate.

The distance between the membrane and the surface of the substrate is preferably provided and/or defined by one or more spacer elements. This means that the substrate and the mask are preferably in connection with each other via one or more spacer elements. The spacer elements are preferably connected to the surface of the substrate and the surface of the membrane. Hence, the mask and the substrate are preferably fixedly attached to one another particularly preferably via one or more spacer elements. The distance between the substrate and the mask is thus preferably kept constant during the deposition. However, it is likewise conceivable that the substrate and the mask are individual components a position of which, $i.e.$ a distance, a rotating angle and/or a tilting angle, are individually set and/or changed.

The substrate and the mask preferably comprise or consist of materials and/or are manufactured according to manufacturing steps that are well-known in the field of depositions such as vacuum depositions. To this end, the substrate and/or the mask can comprise or consist of one or more materials that are well-known in the field of the art.

For example, the mask preferably comprises or consists of silicon and/or a silicon-compound such as silicon

nitride ($SiN_x$). To this end it is conceivable to manufacture $SiN_x$ masks from a silicon wafer wherein a $SiN_x$ membrane is deposited on both sides of the silicon wafer, for instance by low-pressure chemical vapor deposition. Firstly, the apertures can be formed and in particular patterned in the $SiN_x$ membrane on one side of the silicon wafer, herein called the frontside, for instance by lithography such as electron beam lithography followed by etching such as reactive ion etching. Windows can be opened on the opposite side of the wafer, herein called the backside, for instance by lithography such as UV lithography. The bulk silicon can be etched through the opened windows by etching such as deep reactive ion etching and/or KOH wet etching to release the $SiN_x$ membranes on the front side. After membrane release, the wafers can be cleaved into chips for a patterning process, herein sometimes referred to as nanopatterning process, *i.e.*, a process for the patterning of the apertures in the membrane. For instance, the mask can comprise or consist of a sheet of a free-standing membrane supported by a solid window frame. The window frame is preferably fabricated on a silicon wafer, with the window made by the through-silicon etching. The membrane is preferably made from a polymer or inorganic silicon nitride ($SiN_x$) / silicon oxide ($SiO_2$). The apertures are made on the membrane by electron-beam- or photo- lithography followed by membrane etching. A thickness of the mask along a thickness direction of the mask, in particular a thickness of the membrane such as the polymer or inorganic silicon nitride along a thickness direction of the membrane, preferably is in the range of 1 nanometer to 2000 nanometers, such as 10 to 1000 nanometers. The mask can preferably be recycled and/or reused.

The spacer elements between the mask and substrate can be prepared either on the surface of the substrate, or on the surface of the mask, or independently from the mask and substrate. The spacer element is preferably made to precisely define the distance or separation between the membrane and the substrate to be deposited. The substrate and preferably the spacer elements can be attached to the mask, in particular its membrane, by a hard contact such as through magnets placed on both sides. The spacer element preparation can be described as follows: i) Spacer elements prepared on the substrate can be either based on organic elements such as photoresists or inorganic elements such as silicon oxide deposited by plasma enhanced chemical vapor deposition (PECVD). In the case of organic spacer based on photoresist, a photoresist layer can be spun-coated and baked on a precleaned silicon wafer with acetone and isopropanol in sequence. Different heights of the spacer element can be produced using different photoresist types or different spin speeds. After exposure and development, the wafer can be cleaved into chips for the patterning process. In the case of inorganic spacer elements based on silicon oxide, a silicon oxide layer is deposited on the substrate by PECVD. Then photolithography and reactive ion etching are used to etch silicon oxide regionally and open the areas on the substrate where the deposition patterning occurs in the nanopatterning process. Different heights of the spacer element can be produced by varying the thickness of deposited silicon oxide layer. ii) Spacer elements prepared on the mask can be either based on organic elements such as photoresists or inorganic elements such as silicon oxide deposited by plasma enhanced chemical vapor deposition (PECVD). The fabrication process is similar to that in i). In the both cases of organic and inorganic spacer elements, the areas where the apertures located on the mask are opened in order to allow the beam of materials passing through during the nanopatterning process. iii) Spacer elements can be independent from the mask and substrate. In other words, it can be external objects and simply placed between the mask substrate. For instance, commercially available O-rings with well-defined width and height.

A thickness of the membrane along the thickness direction of the membrane is preferably smaller than a critical dimension of the apertures. The critical dimension of the apertures refers to the smallest or shortest feature size or spacing of the apertures. If the membrane is thicker than the critical dimension size of the aperture, sidewalls of the apertures could block the beams of material from certain angles during deposition and the material adsorbing on the sidewalls leads to aperture clogging, such that very little material would arrive on the substrate. Additionally or alternatively, surface treatments can be introduced on the mask to alleviate the material clogging by avoiding the material adsorption on the aperture sidewalls. Surface treatments can be realized by self-assembled monolayer modification or local mask surface heating. An area expansion of the mask and/or of the membrane along an extension direction running perpendicularly to the thickness direction of the membrane preferably is, for instance, between 1 micrometer to 10'000 micrometers, although other area expansions are likewise conceivable. An area expansion of the substrate along an extension direction running perpendicularly to the thickness direction of the substrate preferably is, for instance, 1 micrometer to 10'000 micrometers, although other area expansions are likewise conceivable.

A shape of the apertures can be the same or different from one another. A clear width of the apertures can be the same or different from one another. The apertures are preferably arranged in a pattern, for instance in a square pattern or a hexagonal pattern or a bullseye pattern. An edge-to-edge spacing between neighbouring apertures can be the same or different from one another.

The apertures can have a variety of shapes. For example, the apertures can be circular or can be slits. It should be noted that any shape is possible and/or conceivable. In fact, and as will be explained in greater detail further below, the present invention also provides a computer-implemented method of determining operation parameters for producing the deposition structure on the substrate, which also allows to design the apertures and its pattern exposure so that there is no limit in the shape.

A clear width of the apertures can be the same or different from one another. For example, a diameter of the circular apertures can be the same or different from one another. Conceivable diameters are, for instance, between 1 nanometer to 10'000 nanometers, although other diameters are likewise conceivable. Additionally or alternatively, a length and/or a width of the apertures in the form of slits can be the same or different from one another. Conceivable lengths and/or widths are, for instance, between 1 nanometer to 10'000 nanometers, although other lengths and/or widths are likewise conceivable. An edge-to-edge spacing between neighbouring apertures can be the same or different from one another. Conceivable edge-to-edge spacings are, for instance, between 1 nanometer to 10'000 nanometers, although different spacings are likewise conceivable.

The apertures can be arranged in an array or a pattern, for instance in a square array or a hexagonal array or a bullseye pattern. In a square array, the apertures are preferably equally spaced from each other and arranged in parallel lines extending along a first direction and along a second direction that is perpendicular to the first direction. In a hexagonal array, the apertures are preferably arranged along parallel lines extending along the first direction (second direction), with apertures being offset from apertures of adjacent lines along the second direction (first direction). An offset is preferably the same in each case. The first direction or the second direction preferably runs parallel to the extension direction of the mask. The first direction and the second direction preferably run perpendicularly to the thickness direction of the mask. In a bullseye pattern, the apertures are preferably arranged according to concentric circles.

The deposition structure preferably is a nanostructure, in particular a three-dimensional nanostructure. Additionally or alternatively, the deposition structure preferably has a spatial extension along at least one and preferably along three spatial directions being in the nanometer range.

In particular, the deposition structure preferably has elevations protruding from the surface of the substrate and optionally also "depressions" formed between them, which depressions can be formed by less deposited material or a lack of deposited material, for instance. The height of the protrusions and the depth of the depressions is preferably in the nanometer range. In other words, the deposition thickness of the deposition structure preferably is in the nanometer range. Additionally or alternatively, a distance between adjacent elevations and/or depressions is preferably in the nanometer range with respect to a direction perpendicular to the thickness direction, such as the aforementioned expansion direction of the substrate. Hence, the deposition structure can be seen as a three-dimensional nanostructure, *i.e.* the deposition structure preferably extends in the nanometer range along all three spatial dimensions.

That is, the present invention enables a height variation for the deposited material, which is preferably due to the addition and superposition of the beams of material. The height variation for the deposited material pattern is, for instance, between zero to 1,000 nanometers, although other variations are likewise conceivable. The maximum height and/or a total amount of material deposited on the substrate is preferably set by controlling over a deposition rate and/or a duration of the deposition from the depositor.

The material preferably comprises or consists of one or more metals or metal compounds and/or one or more oxides such as metal oxides and/or one or more organic molecules and/or mixtures thereof. Preferred organic molecules are those that can be evaporated without a decomposition and/or that have a molecular weight of smaller than 10,000 Da. In fact, conceivable materials are any materials that can be deposited by a physical vapor deposition process, such as nitrides, sulphides, and pure elements.

The material can be air-sensitive and/or liquid-sensitive. The air- and liquid-sensitive materials refer to materials whose properties degrade upon expose to air or liquid, respectively.

The material preferably is directly deposited and/or deposited under dry conditions, in particular in the absence of any resists and solvents.

The material is deposited preferably in the form of a beam of material. Said beam of material preferably corresponds to a material flux formed by heating (or ion-bombarding) the material in vacuum and/or in a sublimation process. As such, the material range is preferably limited only by the means of material deposition.

At least a further material is preferably deposited. The substrate and/or the mask are preferably tilted before and/or during the deposition of the further material such, that an interference of two or more beams of the further material is different from an interference between two or more beams of the material.

Additionally or alternatively, the substrate and/or the mask are preferably tilted before and/or during the deposition of the further material such, that a modulation of an amount of further material deposited at specific positions on the surface of the substrate and/or on the material deposited on the surface of the substrate is different from a modulation of an amount of the material deposited at specific positions on the surface of the substrate.

Additionally or alternatively, the substrate and/or the mask are preferably tilted before and/or during the deposition of the further material such, that a spatial displacement of the further material being deposited on the surface of the substrate and/or the material deposited on the surface of the substrate with respect to a reference-incidence position of said further material normal to the surface of the substrate is different from a spatial displacement of the material with respect to a reference-incidence position of said material normal to the surface of the substrate.

That is, two or more further materials can be deposited using the same substrate and mask, but with different degrees of interference of the beams of said further materials as compared to the interference of the beams of the material.

The two or more further materials are preferably different from one another and different from the material. For instance, a second material could be used that differs from the material, now called first material, wherein a binary deposition structure is formed. Alternatively, three different materials could be used, yielding a tertiary deposition structure, *etc.* In fact, and as will be explained in greater detail below, all kinds of combinations of binary, tertiary, *etc.* deposition structures comprising two, three, *etc.* different materials can be produced by varying the tilting angle and/or the rotating angle of the mask and/or the substrate before and/or during the deposition of these further materials.

Said binary, tertiary *etc.* deposition structures preferably are self-aligned. That is, compared to prior art patterning processes, where optical/mechanical/physical overlay alignment is required in the event of two mor more materials being deposited, such procedure is not required in the present invention. This is because the degree of spatial displacement can be precisely determined by the operation parameters of the deposition, wherein further materials can be patterned adjacent to the first material by tuning the tilting and/or rotating angle. Moreover, during the depositions, a location of mask with respect to the substrate does not need to be changed, *e.g.*, the mask does not need to be detached from the substrate, so that the distance and the reference-incidence position of said material and of any further materials remains the same. In other words, two or more material patterns can be stacked on each other in a precise manner without the need of a mechanically overlay alignment.

It is conceivable that only one material, *i.e.* a single material, is deposited on the surface of the substrate.

However, it is likewise conceivable that two or more materials are deposited. For a better understanding, said two or more materials are called first and second materials. The first material preferably corresponds to "the material" mentioned above and is deposited on the surface of the substrate as explained herein above. The second material is preferably deposited after the first material has been deposited. To this end it is conceivable that at least part of the second material is deposited on the surface of the substrate and/or on the first material. However, it is likewise conceivable that the second material is deposited on the surface of the substrate only but not on the first material. It is furthermore conceivable that the second material is deposited on the first material only but not on the surface of the substrate. Said two or more materials are preferably deposited in a single run and/or in sequence.

A rotation and/or tilting before and/or during the deposition of the second material can be the same or different from the rotating and/or tilting during the deposition of the first material. This results in several possible deposition scenarios. For example, the rotating angle about which the substrate and/or the mask is rotated before and/or during the deposition of the first material and a rotating angle about which the substrate and/or the mask is rotated before and/or during the deposition of the second material can be the same or different from one another. Additionally or alternatively, the tilting angle between i) the substrate and/or the mask and ii) the depositor before and/or during the deposition of the first material and a tilting angle between i) the substrate and/or the mask and ii) the depositor before and/or during the deposition of the second material can be the same or different from one another. Additionally or alternatively, it is conceivable that the substrate and/or the mask is, at least temporarily, not rotated and/or not tilted during the deposition of the second material. In other words, it is conceivable that the substrate and/or the mask is at least temporarily stationary during the deposition of the second material.

For example, the first material such as elementary silver (Ag) can be deposited while the substrate and the mask are tilted with respect to the depositor by a tilting angle of 5° while the substrate and the mask rotate during the deposition by a rotating angle of 270°. The rotating angle of 270° means that the substrate and the mask are rotated between the beginning of the deposition until the end of the deposition by a rotating angle of 270°. After the deposition of said first material, the second material such as elementary Germanium (Ge) can be deposited, while neither the substrate nor the mask are tilted but arranged at a tilting angle of 0° with respect to the depositor, but while the substrate and the mask are rotated by a rotating angle of 270°. That is, the rotating angle during the deposition of the first and the second materials is the same, while the tilting angles are different. As another example, the second material could be deposited under the same tilting angle as the first material, but wherein the rotating angle could be different, for instance 315° offset as compared to the rotating angle under which the first material has been deposited.

Hence, the tilting angle does not need to be changed during the deposition but can be kept constant. When the tilting angle is kept constant and when the substrate is constantly rotated, for instance, a deposition structure being radially symmetrical such as donut or ring shaped can be formed. If the tilting angle is preferably constantly changed during the deposition, other shapes such as a spiral deposition structure can be formed.

In another aspect, a computer-implemented method of determining operation parameters for producing a deposition structure on a substrate as described above is provided. The computer-implemented method comprises the steps of:

- Receiving, at a computing device, at least one mask pattern **M**, wherein the mask pattern **M** is preferably defined as a continuous function M(**x**) using, for instance, a GDSII (Graphic Design System) or DXF format, where **x**($x$, $y$) is a two-dimensional position and $\Omega$ is the domain of the plurality of apertures of the mask:

$$M(\mathbf{x}) = \begin{cases} 1, & \mathbf{x} \in \mathbf{\Omega} \\ 0, & \mathbf{x} \notin \mathbf{\Omega} \end{cases}$$

- Receiving, at the computing device, at least one filter pattern **F,** wherein the filter pattern **F** preferably is a projection of a trajectory $(D, \varphi, \theta)$ onto a surface of the substrate for possible incident locations of material on the substrate, where D is the radius of a parametric hemisphere equal to the separation distance between substrate and the mask, herein also called stencil or stencil membrane, $\varphi$ is the tilting angle and $\theta$ is the rotating angle;
- Generating, at the computing device, an output set of operation parameters corresponding to a morphology of the deposition structure on the surface of the pattern by determining a probability pattern from a convolution of the filter pattern **F** and the mask pattern **M.**

Said output set of operation parameters is preferably transmitted to a depositor arrangement comprising a depositor, a mask and a substrate as mentioned above, and wherein the operation parameters and wherein the depositor and/or the mask and/or the substrate are operated or controlled based on the operation parameters. In particular, the operation parameters are used to control the tilting angle(s) and/or the rotating angle(s) between i) the substrate and/or the mask and ii) the depositor.

Hence, in another aspect a non-transient computer readable medium being encoded with a computer program product comprising computer code that, when executed in a processor, cause the processor to perform the method of producing a deposition structure on a substrate and/or of determining operation parameters for producing a deposition structure on a substrate as described above.

In another aspect, a depositor arrangement comprising a depositor, a mask and a substrate as described above, a processor, and the non-transient computer readable medium as described above is provided.

Hence, the depositor arrangement can be seen as a combined software and hardware package, wherein at least one of the depositor, mask and substrate, preferably the tilting and/or rotational angles, can be controlled as a function of time, to produce a desirable deposition structure preferably defined by a user.

That is, the computer-implemented method preferably allows the user to predict / inverse-design the mask and filter patterns. This can be seen as a "Design Phase", wherein the operation parameters are determined. Thereafter, said operation parameters are preferably used in a "Control Phase", wherein the components of the depositor arrangement are preferably controlled based on said operation parameters.

At the "Design" phase, the users can draw the mask and filter patterns using a CAD (computer-aided design) software, such as AutoCAD and KLayout Editor, on a computer or workstation for the generation of two DXF or GDSII files, which will then be used to predict the deposited morphologies of the deposition structure in the computer-implemented method according to the invention. The computer-implemented method can be configured to indicate said prediction to the user and, upon confirmation, the "Control Phase" is initiated and the depositor arrangement, in particular the rotating / tilting angles are preferably controlled as a function of time during the deposition according to the user's filter pattern design, yielding the deposition structure of the designed morphology.

As for the detailed steps at the "Design" phase, they are preferably as follows:

Determination of the mask pattern **M:** to this end it is preferred that a computing device receives at least one mask pattern **M.** A user can directly draw the mask pattern **M** using a CAD software. The mask pattern preferably is a continuous function M($\mathbf{x}$) where $\mathbf{x}$(x,y) is a two-dimensional position, and $\Omega$ is the domain of the plurality of apertures of the mask:

$$M(\mathbf{x}) = \begin{cases} 1, & \mathbf{x} \in \mathbf{\Omega} \\ 0, & \mathbf{x} \notin \mathbf{\Omega} \end{cases} \qquad (S1)$$

Determination of the filter pattern **F:** subsequently, it is preferred that the computing device receives at least one filter pattern **F.** The filter pattern **F** preferably is a projection of a trajectory $(D, \varphi, \theta)$ onto a surface of the substrate for possible incident locations of material on the substrate. To this end D is the radius of a parametric hemisphere, $\varphi$ is the tilting angle and $\theta$ is the rotating angle.

In particular, for a location $\mathbf{x}$=(x, y) on the substrate, an exposure event of the material to be deposited can be characterized by the trajectory $(D, \varphi, \theta)$. The filter pattern **F** corresponds to the projection of the trajectory onto the substrate plane. The user can draw the filter pattern **F** in a CAD software.

Generating an output set of operation parameters: subsequently, it is preferred that the computing device generates an output set of operation parameters corresponding to a morphology of the deposition structure on the surface of the pattern by determining a probability pattern from a convolution of the filter pattern and the mask pattern.

In particular, an actual incident flux of the material arriving at the substrate is preferably calculated, wherein an incident flux arriving at the mask plane at $\mathbf{x}_m = (x_m, y_m) = \mathbf{x} \cdot \mathbf{u}$ on the mask plane is determined in a first step. $\mathbf{x}$ and $\mathbf{u}$ are location vectors for the material flux arriving on the mask or stencil membrane and the substrate, respectively. The length of the vector $\mathbf{u}$, $|\mathbf{u}|$, is given by: $|\mathbf{u}| = D\tan\varphi + R_s$. $R_s$ is a material-dependent parameter, the surface diffusion distance, which is extracted by fitting the deposition structure with our theoretical model $\mathbf{P}(x,y)$ (see below).

A summation of all possible incident locations xm forms the filter pattern F. Assuming a uniform material flux $\Phi_0$ without any mask or stencil, the material flux at point x is preferably determined from:

$$\Phi(\mathbf{x}) = \iint_{-\infty}^{\infty} \Phi_0 F(\mathbf{u}) M(\mathbf{x} - \mathbf{u}) w(\mathbf{u}) \, d\mathbf{u} \qquad (1)$$

where w($\mathbf{u}$) represents the weight for each exposure event associated with vector $\mathbf{u}$. For operations at uniform speed, w($\mathbf{u}$) =1. Then, the deposition probability P(x, y)=P($\mathbf{x}$) is preferably determined, which is preferably defined as the ratio between $\Phi(\mathbf{x})$ and $\Phi_0$ as follows:

$$P(\mathbf{x}) = \iint_{-\infty}^{\infty} F(\mathbf{u}) M(\mathbf{x} - \mathbf{u}) \, d\mathbf{u} \qquad (2)$$

As follows from the above equation, the deposition probability preferably is determined from a convolution operation between the filter pattern and the mask pattern. When F($\mathbf{u}$) and M($\mathbf{x}$) are represented using discrete matrices, $\mathbf{F}$ and $\mathbf{M}$, respectively, the resulting probability matrix $\mathbf{P}$ can be written as $\mathbf{P}$ = Conv($\mathbf{F}$, $\mathbf{M}$). The probability pattern $\mathbf{P}$ corresponds to the morphology predicted by the computer-implemented method according to the invention. Most operation parameters, including D, $\varphi$, and $\theta$, are preferably directly defined by the users. The only remaining parameter, $R_s$, is material dependent and is preferably determined by fitting the actually resulting pattern with the calculated probability matrix P.

In another aspect, a deposition structure as described above is used as a display device or as part thereof, preferably as an organic optoelectronic device or a part thereof such as a light-emitting diode (OLED) display, and/or as a metasurface for instance in an optical device such as meta-lens.

That is, the deposition structure can be used as a displace device, for instance of a Virtual Reality (VR) and/or Augmented Reality (AR) device. To this end it is preferred that the deposition structure provides an OLED display device, in particular a micro-OLED display device, or forms part thereof. To this end an OLED display device can be provided that is configured to exhibit different OLED colors, for instance by using a deposition structure that is formed from different organic molecules, which can be deposited in the method according to the invention and in particular in a self-aligned manner, without involving solvent-involved photolithography.

Hence, the method according to the invention is particularly useful for low-cost and scalable fabrication of metasurfaces and nanoscale organic optoelectronic devices. For example, the method according to the invention can be used to fabricate nanoscale pixelized OLEDs, reaching > $10^5$ pixel per inch (ppi) resolution.

Other applications are of course likewise conceivable.

BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,

Fig. 1 shows a schematic of a deposition arrangement for depositing a deposition structure on a substrate a characterization of the deposition structures, wherein the deposition arrangement comprises a depositor, a mask, and a substrate;

Fig. 2 shows a schematic of a mask device of the deposition arrangement in the form of a membrane comprising apertures;

Fig. 3 shows aspects of a computer-implemented method of determining operation parameters for producing a deposition structure on a substrate with a deposition arrangement according to the invention;

Fig. 4 shows atomic force microscopy (AFM) images of different deposition structures according to the invention;

Fig. 5 shows a deposition of multiple materials with self-alignment capability using the method according to the invention;

Fig. 6 shows a characterization of the influence of a gap between the mask and the substrate and a tilting angle of the substrate in the method according to the invention;

Fig. 7    shows a characterization of the influence of mask design and substrate tilting angle in the method according to the invention;

Fig. 8    shows an influence of the deposited material property on the properties of the deposition structures in the form of deposited ring;

Fig. 9    shows SEM characterizations of deposition structures of various materials that were deposited through masks with different aperture designs;

Fig. 10   shows further SEM characterizations of deposition structures of various materials that were deposited through masks with different aperture designs;

Fig. 11   shows characterizations of deposited binary deposition structures combing Ag and Ge;

Fig. 12   shows a fluorescent micrograph (left) and a corresponding tilted topography image (right) of an Ir(ppy)$_3$ deposition structure;

Fig. 13   shows AFM images showing positive-tone (left) and negative-tone (right) deposition structures formed by using the mask but with different θ-φ trajectories;

Fig. 14   shows a comparison of complex deposition structures predicted by the computer-implemented method according to the invention (top images) and AFM images of actually fabricated deposition structures (bottom images);

Fig. 15   shows AFM images showing deposition structures according to the invention that are deposited using the same mask but with different θ-φ trajectories.

## DESCRIPTION OF PREFERRED EMBODIMENTS

With reference to the figures various aspects of the production of a deposition structure 1 according to the invention are illustrated.

In fact, and as will be outlined in greater detail below, the method according to the invention enables a direct 3D depositing various materials 6, 6a, ... including metals, oxides and small organic molecules with diverse deposition structures 1. Due to the small scales that are reachable with the method according to the invention, said deposition and the resulting deposition structure 1 can also be referred to as nanopatterning nanostructures. Meanwhile, a self-alignment capability provided by the method according to the invention allows for nanopatterning of multiple materials 6, 6a, ... in a single run simply by tuning the patterning parameters. Binary, up to quintenary nanostructures of multiple materials 6, 6a, ... can be generated. This technique works similarly to conventional holographic lithography based on the interference of coherent laser beams[11], but acting as molecular beam interaction. From hereon, it is also referred to as molecular beam holographic lithography (MBHL). The patterning process can occur in a purely dry condition, without the need for resists or solvents.

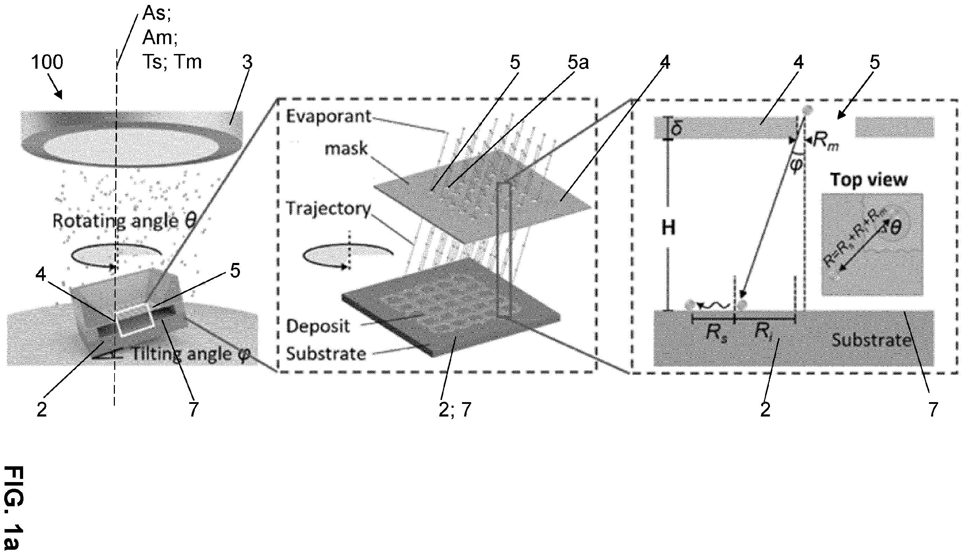

Figure 1a gives a schematic overview of the MBHL fabrication setup in the form of a depositor arrangement 100 comprising a depositor 3, a mask 4 and a substrate 2. The depositor 3 is configured to deposit at least one material 6 and the mask 4 comprises a plurality of apertures 5, 5a, .... Upon depositing material 6 from the depositor 3, part of the material 6 passes through the apertures 5, 5a, ... of the mask 4 and is deposited on the surface 7 of the substrate 2, whereby at least one deposition structure 1 is formed on the surface 7 of the substrate 2. In the depicted example, a rotating angle θ between i) the substrate 2 and the mask 4 and ii) the depositor 3 is at least temporarily changed before and/or during the deposition of the material 6. Moreover, a tilting angle φ between i) the substrate 2 and the mask 4 and ii) the depositor 3 is at least temporarily changed before and/or during the deposition of the material 6. In the depicted example, the mask 4 and the substrate 2 are a single component, wherein the mask 4 is spaced at a distance from the substrate 2 via spacer elements 8. Hence, the mask 4 and the substrate 2 are rotated and tilted in a common manner. In particular, the substrate 2 is rotated about a rotation axis As that runs centrally through the substrate 2 and the mask 4 is rotated about a rotation axis Am that runs centrally through the mask 4, wherein the rotation axes As, Am of the substrate and the mask run parallel to one another. Furthermore, the substrate 2 is tilted about a tilting axis Ts that runs centrally through the substrate 2 and the mask 4 is tilted about a tilting axis Tm that runs centrally through the mask 4, wherein the tilting axes Ts; Tm of the substrate 2 and the mask 4 run parallel to one another. In addition, the rotation axes As, Am and the tilting axes Ts, Tm run parallel to one another as well.

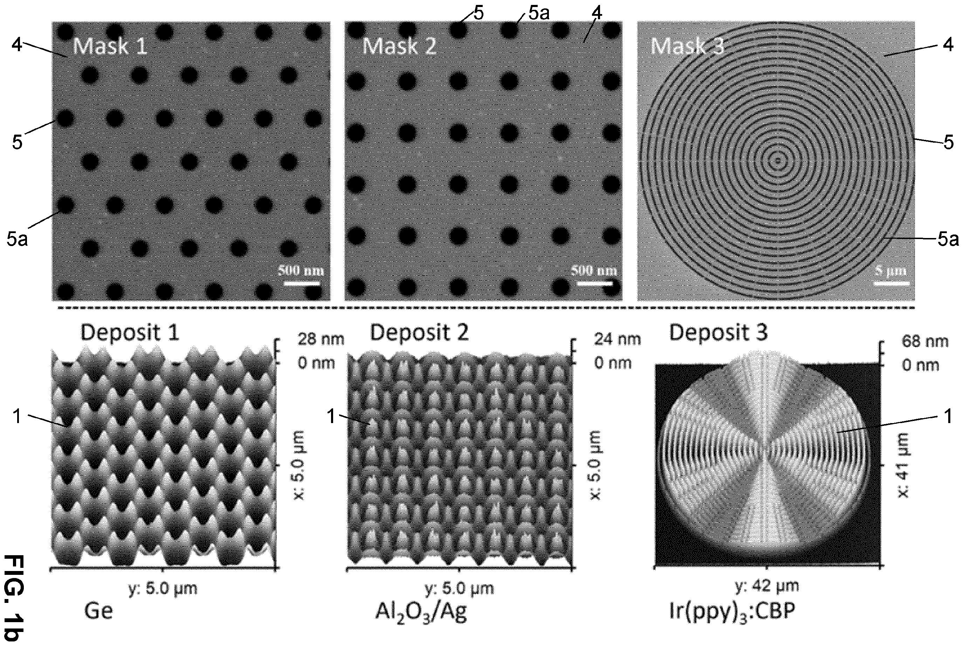

A conceivable working principle of MBHL is as follows: the depositor 3 can be a physical vapor depositor (PVD), wherein a material vapor of atoms or molecules 6, *i.e.* evaporants, from the PVD pass through a mask 4 such as a silicon nitride (SiN$_x$) mask in a tilting angle φ, landing on the substrate 2 while maintaining a well-defined distance or gap H between the mask 4 and substrate 2, interacting with neighboring atoms/molecules when the mask 4 and substrate 2 rotate in the same speed, and then forming the final 3D nanostructures guided by the apertures 5, 5a, ... in the mask 4. That is, and as follows from figures 1a, both the SiN$_x$ mask 4 and the substrate 2 rotate in the same speed. As a result, complex deposition structures are formed on the substrate 2. Figure 1b depicts scanning electron microscope (SEM) images of three different kinds of SiN$_x$ mask design and corresponding deposition structures that are generated on the substrate 2 by varying the deposition conditions. Mask 1: apertures 5, 5a, ... having a diameter of 200 nm are arranged in a hexagonal arrangement with a spacing (*i.e.* center-to-center distance) of 700 nm; Mask 2: apertures 5, 5a, ... having a diameter of 200 nm are arranged in a square arrangement with a spacing (*i.e.* center to center distance) of 700 nm; Mask 3: apertures 5, 5a, ... in the form of a Bullseye structure with a gap of 200 nm between neighboring trenches. Deposit 1: Ge is deposited, in particular evaporated in 5° tilting angle $\varphi$ of the substrate 2 and the mask 4 with respect to the depositor 3 and the deposition thickness is 100 nm; Deposit 2: $Al_2O_3$ is deposited, in particular evaporated in 5° tilting angle $\varphi$ of the substrate 2 and the mask 4 with respect to the depositor 3 and the deposition thickness is 100 nm. Ag is evaporated without tilting and the deposition thickness is 50 nm; Deposit 3: A deposition structure in the form of a Moiré pattern is formed by evaporating $Ir(ppy)_3$: 4,4' -Bis(N-carbazolyl)-1,1' - biphenyl (CBP) in 5° tilting angle $\varphi$ and -5° tilting angle $\varphi$, respectively. The deposition thickness each time is 100 nm.

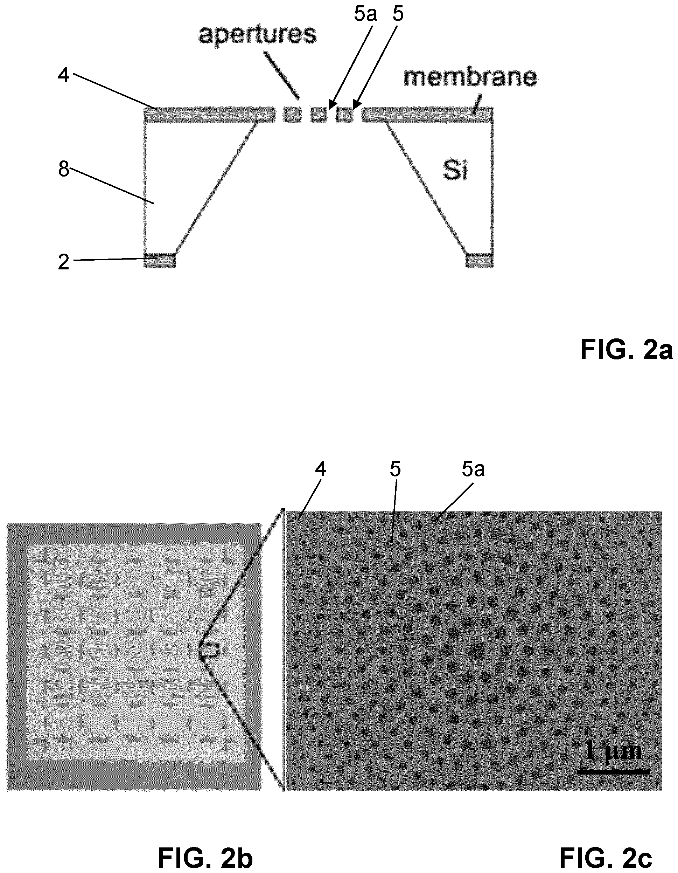

Figure 2 depicts schematics of a mask 4 comprising apertures 5, 5a, .... In particular, figure 2a depicts the formation of said mask 4, wherein a layer of polymer or inorganic membrane is deposited on a silicon wafer, followed by high-resolution photolithography (EBL, DUV or EUV) patterning to define and etch the apertures 5, 5a, .... The underlying silicon substrate was later removed by deep-silicon and/or wet etching, which defines silicon windows. Figure 2b depicts an optical micrograph image showing such a aperture membrane 4 suspended on a silicon window that is provided by means of the substrate 2 and the spacer element 8 as illustrated in figure 2a. Figure 2c depicts an SEM image of such apertures 5, 5a, ... fabricated on the membrane 4.

Hence, by varying the patterning conditions including mask design and substrate tilting angle $\varphi$, a variety of nanostructures were produced, many of which were previously unattainable. As will be outlined in greater detail below, the production of such deposition structures or nanostructures is further enabled by a computer-implemented method of determining the corresponding operation parameters of the depositor arrangement 100, wherein said computer-implemented method allows to precisely predict the deposition structures realized by MBHL, facilitating the design of the deposition structures and guiding the deposition process. This technique enables substantial advances in nanopatterning and may find applications in photonics[12,13], biosensors[14,15] and light-emitting devices[16].

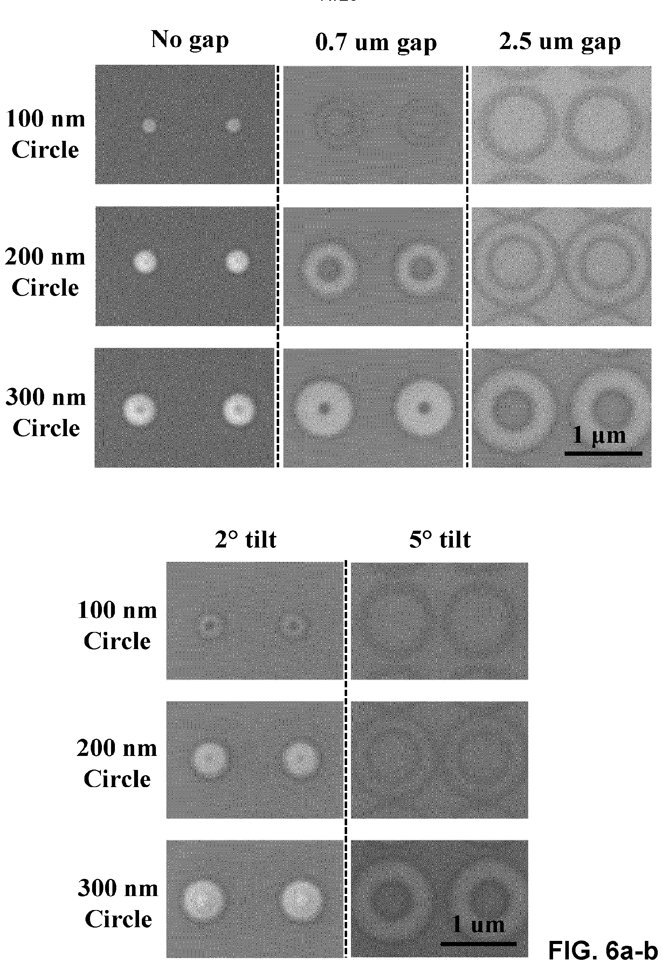

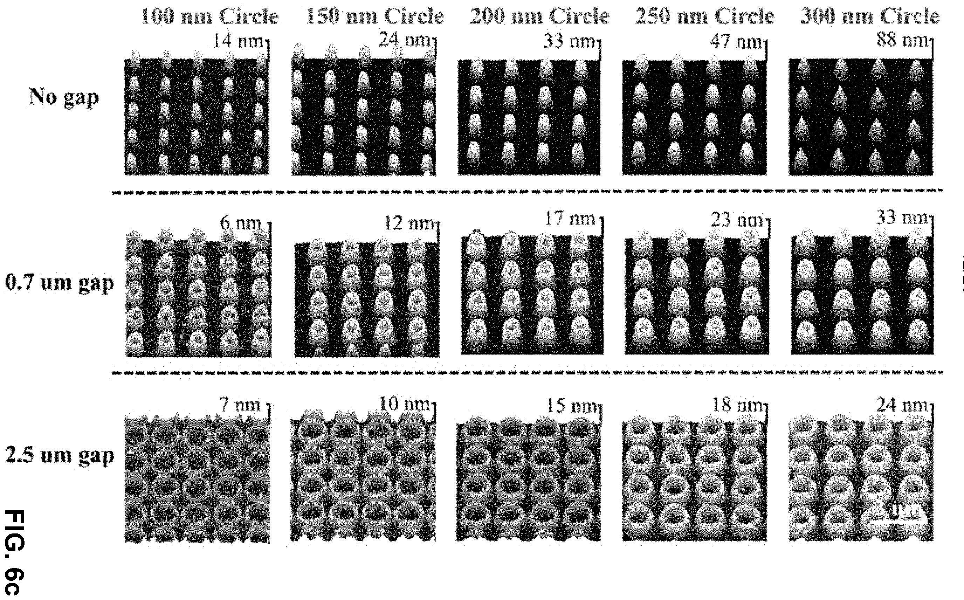

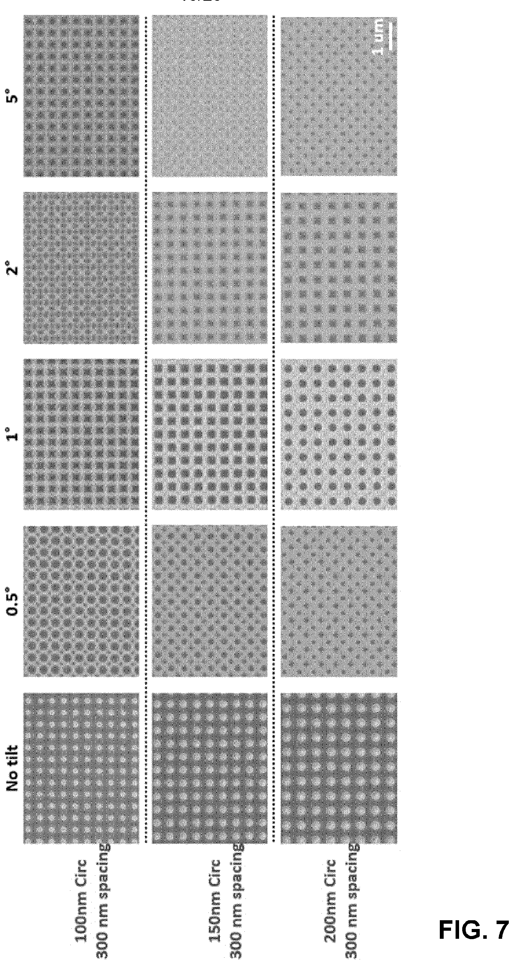

As can be seen from the illustration depicted in Figure 1a, left and middle images, several parameters are critical for MBHL, including mask design such as size of the apertures 5, 5a, ... and distribution in the mask 4, the distance or gap H between the mask 4 and substrate 2, and the tilting angle $\varphi$ between the depositor 3 and the mask 4 and/or the substrate 2. Systematic studies in Figures 6 and 7 show how the aforementioned parameters influence the MBHL process.

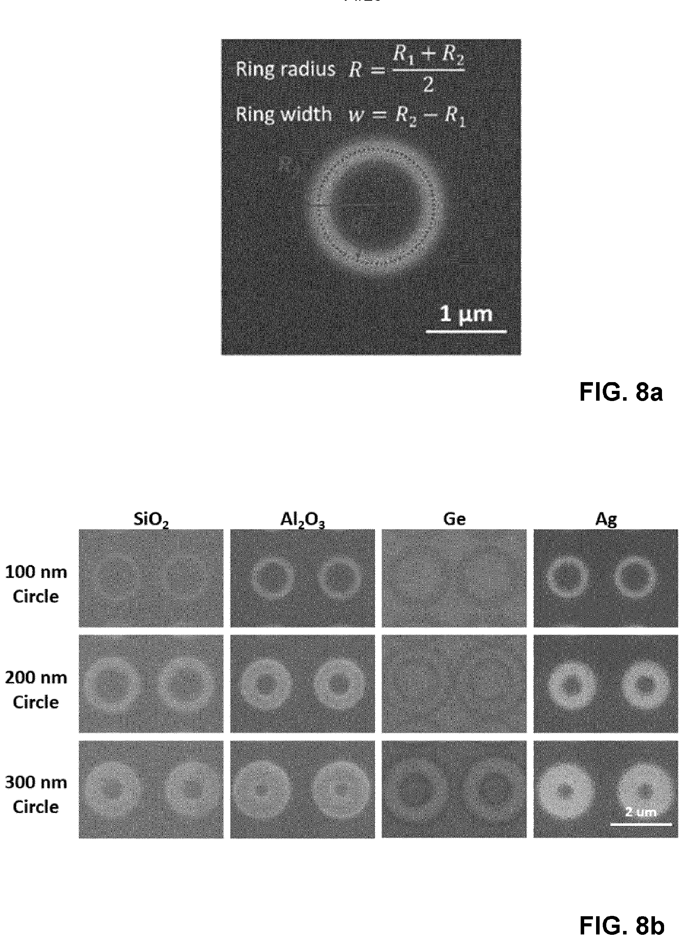

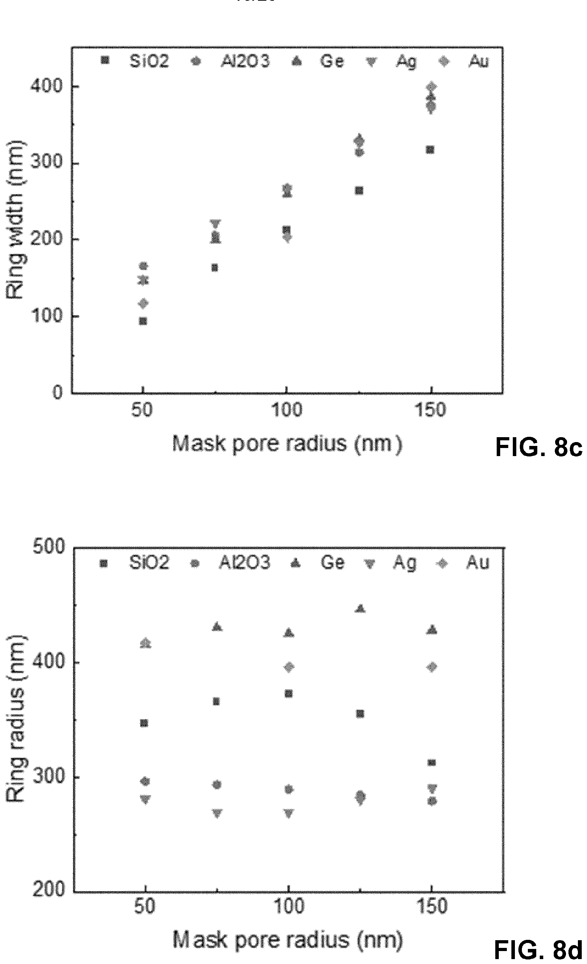

As the tilting angle $\varphi$ or the distance or gap H between the mask 4 and substrate 2 increases while maintaining other parameters unchanged, the deposited patterns change from dot-shaped into ring-shaped (see the AFM characterization in Figure 6c) and interact with neighboring rings when the ring radii become larger than the aperture 5, 5a, ... spacings in the mask 4. In consequence, different deposition structures are generated when the neighboring rings interact to different extents. When the evaporant lands on the substrate 2, it deviates from the incidence point normal to the substrate 2 caused by a combined effect of geometric shift from tilting the substrate 2 and/or the mask 4 and surface diffusion, as shown in Figure 1a, right image. The offset, *i.e.*, a spreading distance R from the perpendicular incidence point, will be the summation of $R_m$ (distance from the mask edge), $R_i$ (incidence shift caused by tilting) and $R_s$ (surface diffusion distance). The spreading distance R can be extracted by fitting the radius of the deposited rings, as depicted in Figure 8. Overall, a strong dependence of R on the material property is observed for the deposition through mask apertures 5, 5a, ..., also called mask pores 5, 5a, ..., with different diameters (Figure 8c). The ring width inherits the dimension from mask design, as seen from the Figure 8d. Figure 1(b) presents three different $SiN_x$ mask designs and corresponding 3D nanopatterns on a silicon substrate 2 by varying the deposition conditions. The 3D nanopatterns display distinct structures from the mask designs. Not only continuous nanostructures of single materials 6 can be produced, but binary nanostructures composed of two different materials 6, 6a, ... or even Moiré patterns can also be obtained.

One remarkable feature of MBHL that distinguishes it from many other lithographic techniques is its ability to modulate the amount of material 6, 6a, ... deposited at specific positions on the substrate 2. This results in the formation of constructive (high density) or vacant (low density) interference patterns, as exemplified by deposits 2 and 3 in Figure 1b. As mentioned earlier, the inventors developed a computer-implemented method of determining operation parameters for producing a deposition structure on a substrate 2, wherein said method can also be referred to as a continuum computational lithography model that allows to systematically investigate the operational principles of MBHL.

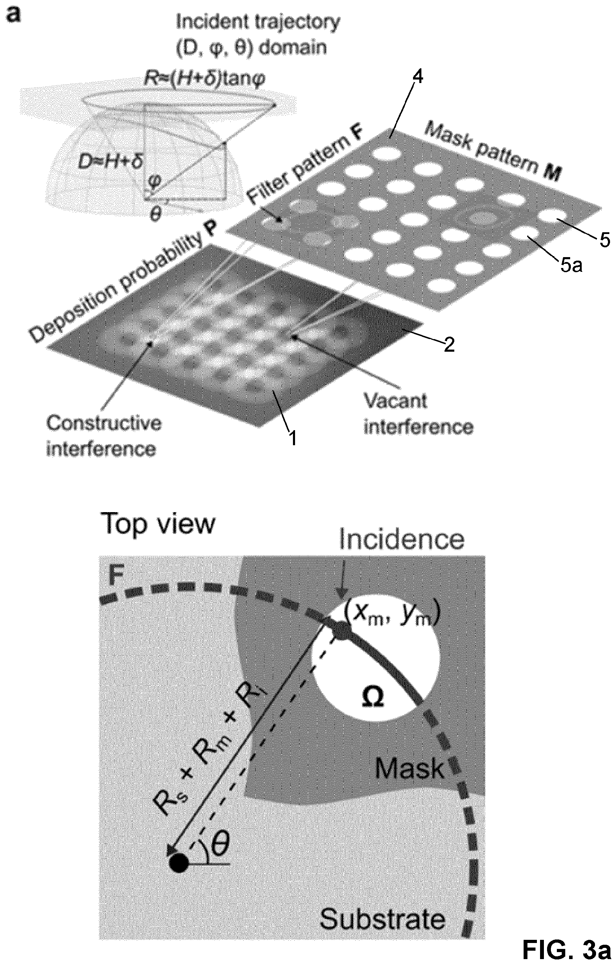

As depicted in Figure 3a, upper images, an exposure event where a finite material flux passes through the mask aperture 5, 5a, ... at a substrate tilting angle $\varphi$ and source rotating angle $\theta$, can be represented as a point $(\varphi, \theta)$ on a parametric hemisphere with radius D, the gap or distance H between the mask 4 and the substrate 2. A complete MBHL procedure is thus equivalent to a trajectory of $(\varphi, \theta)$ points on the hemisphere. For simplicity, we first consider the points within this trajectory to be equal-weighted, representing a uniform substrate and mask rotation and movement speed, i.e., of a substrate-mask stack formed by the substrate and the mask. Within the ballistic transport regime characteristic of MBHL conditions, the trajectories of particles from the mask 4 to the substrate 2 can be approximated as straight lines. Trigonometry shows that for a certain position (x, y) on the substrate 2, all possible incident positions on the mask plane form a filter pattern **F,** which is essentially the projection of the trajectory from the hemisphere onto a 2D plane. The proportional intensity of the material flux at (x, y), **P**(x, y), is directly linked to the overlap between the filter pattern **F** and the mask's apertures 5, 5a, ... , **M** (detailed discussions see Section S1 further below). Mathematically, the 2D deposition probability **P** on the substrate 2 emerges as a convolution of the filter pattern **F** with the mask pattern **M.** In other words, the governing equation of MBHL is:

$$P = \mathrm{Conv}(F, M)$$

$$(1)$$

where Conv is the 2D matrix convolution operation.

Figure 3a, lower image, illustrates a schematic of part of the deposition arrangement viewed from the top. The projected trajectory (filter pattern), **F,** is shown as a dark path.

We next show how such convolutional process of MBHL enables the creation of intricate deposition structures from relatively primitive mask designs and operational parameters.

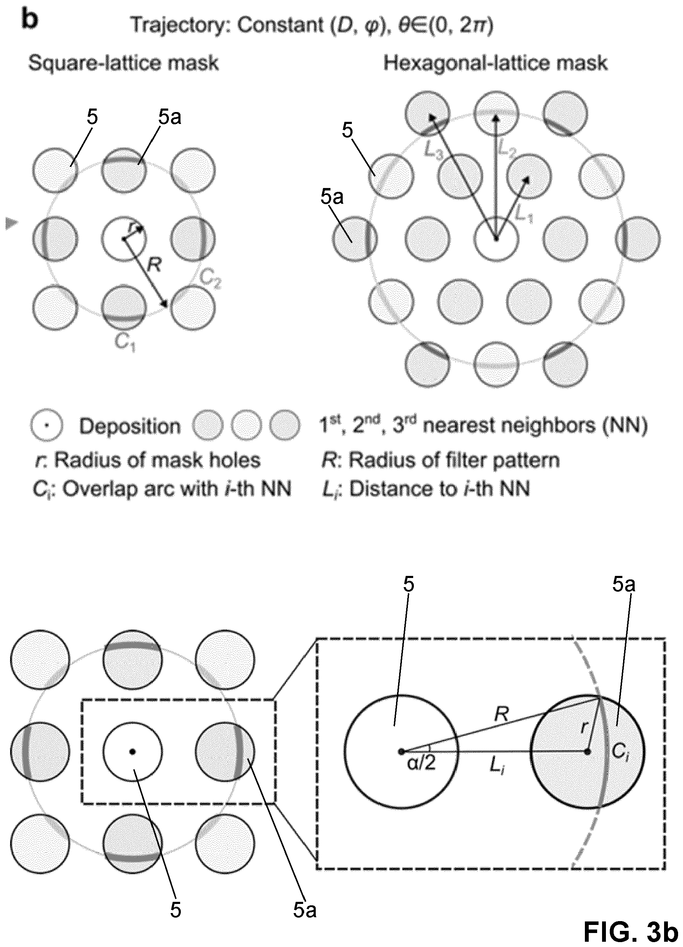

Figure 3b illustrates the geometric interpretation of constructive and vacant interference for masks 4 with square and hexagonal apertures 5, 5a, ..., respectively. Both masks 4 have an aperture radius r and a center-to-center distance L. Under the conditions similar to the deposit sample 1 in Figure 1b, where D and $\varphi$ are constant while $\theta$ evolves from 0 to $2\pi$, the projected filter pattern **F** is a circle with radius R. Assuming negligible lateral diffusion and mask thickness, we have R = Dtan$\varphi$. As stated above, the deposition probability directly below a aperture center Pc, is proportional to the total length of all intersecting arcs $C_i$ between F and the i-th nearest aperture (NN). For instance, Figure 3b shows the constructive deposition using a square mask influenced by the 1st and 2nd NNs, while the contribution for a hexagonal mask 4 comes from the 2nd and 3rd NNs. That is, figure 3b depicts the 2D probability of deposition **P** resulting from a convolution of the mask pattern M with the projected incident trajectory **F** (the filter pattern), resulting in constructive (high intensity) and vacant (low intensity) interference spots, which is depicted as a geometric interpretation of the formation of vacant and constructive interference patterns using square and hexagonal hole masks with hole radius r and spacing of L, and a circular projected filter pattern with radius R. The intensity of deposition directly under the incidence center is proportional to the overlap between the filter pattern and mask pattern.

The general expression for Pc for a periodic mask 4 with circular apertures 5, 5a, ... under such deposition conditions is derived as follows (details see Section S2 further below):

$$P_{\mathrm{c}} = \sum_{i=1}^{\infty} \frac{N_i}{\pi} \mathrm{Re}\left\{ cos^{-1}\left[ \frac{\left(\frac{R}{r}\right)^2 + \left(\frac{L_i}{r}\right)^2 - 1}{2\frac{R}{r}\frac{L_i}{r}} \right] \right\} + \varkappa(r - R)$$

$$(2)$$

where i is the index of the NN, Re is the real part of a complex number, $\varkappa$ is the Heaviside step function, $N_i$ and $L_i$ are the numbers of equivalent apertures 5, 5a, ... and center-to-center distance of i-th NNs, respectively. One can anticipate that vacant patterns may emerge by altering the relative ratio between R and L, until the filter circle no longer intersects with any NNs. The operational parameter space for these systems can be simplified to two dimensionless variables, namely the ratios R/r and L/r.

Details for a deposition arrangement comprising a mask 4 with square-lattice nanopores are depicted in figure 3b, lower image.

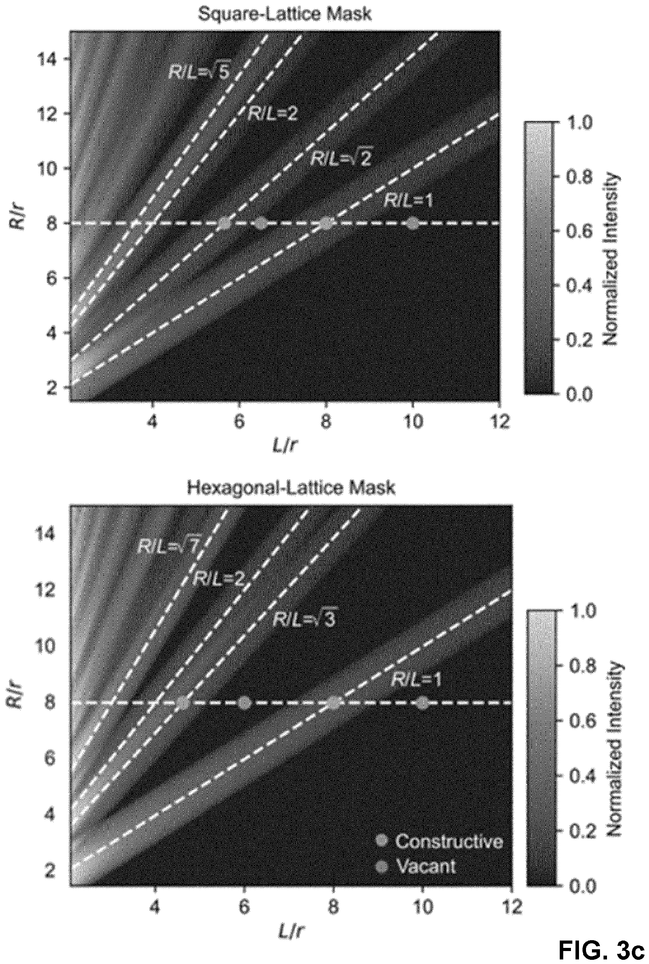

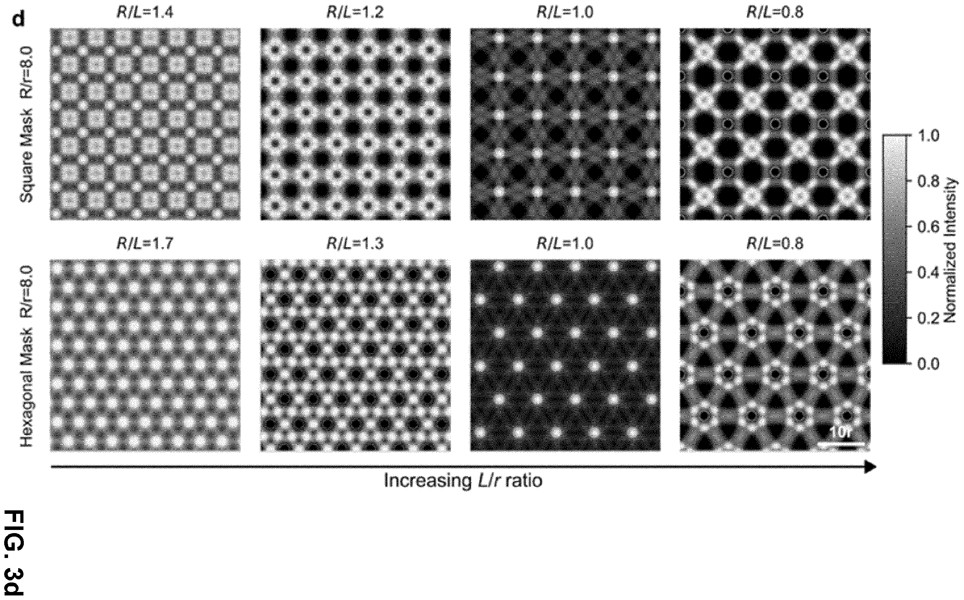

As shown in Figure 3c, the contour plots for the normalized deposition probability of square (left) and hexagonal masks 4 (right) by varying R/r and L/r corresponding to the geometries in Figure 3b, clearly show regimes of constructive (high intensity) and vacant (low intensity) interference. Notably, the centers of the constructive regimes align with lines where the R/L=ci, where ci is a series of constants. For a square mask 4, $c_i = \{1, \sqrt{2}, 2, \sqrt{5}, ...\}$ while for a hexagonal mask 4, $c_i = \{1, \sqrt{3}, 2, \sqrt{7}, ...\}$, in line with our analysis in Section S2 presented further below. Alternating constructive and vacant regimes are observed along a horizontal line at constant R/r values, indicating that deposition structure formation is sensitive to the geometry of the masks 4 (varying L/r ratio) even under the same deposition conditions (constant R/r). The diagonal dashed lines indicate some specific lower-order R/L ratios where constructive interference is observed. The deposition probability alternates between constructive and vacant interference at constant R/r values, as marked in darker and brighter dots, respectively. This effect is corroborated by our simulated deposition structures under the aforementioned conditions, as shown in Figure 3d. That is, figure 3d depicts simulated 2D deposition probability patterns for square (upper row) and hexagonal (lower row) masks 4 at R/r = 8, corresponding to the marked configurations in Figure 3c. The positions of the mask holes are labeled by circles.

The deposition structure design rules outlined above are further validated through experimental methods.

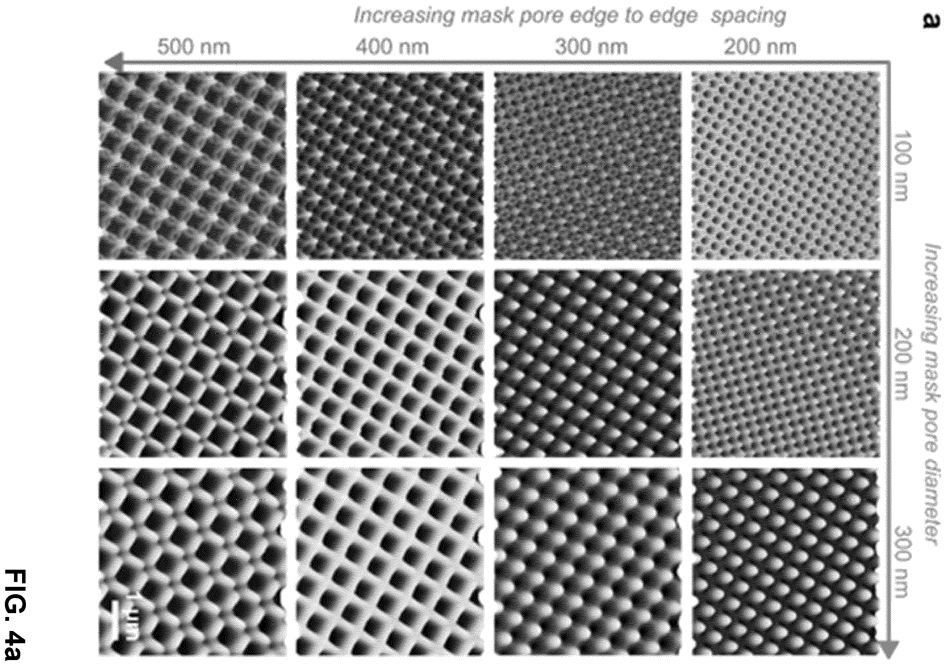

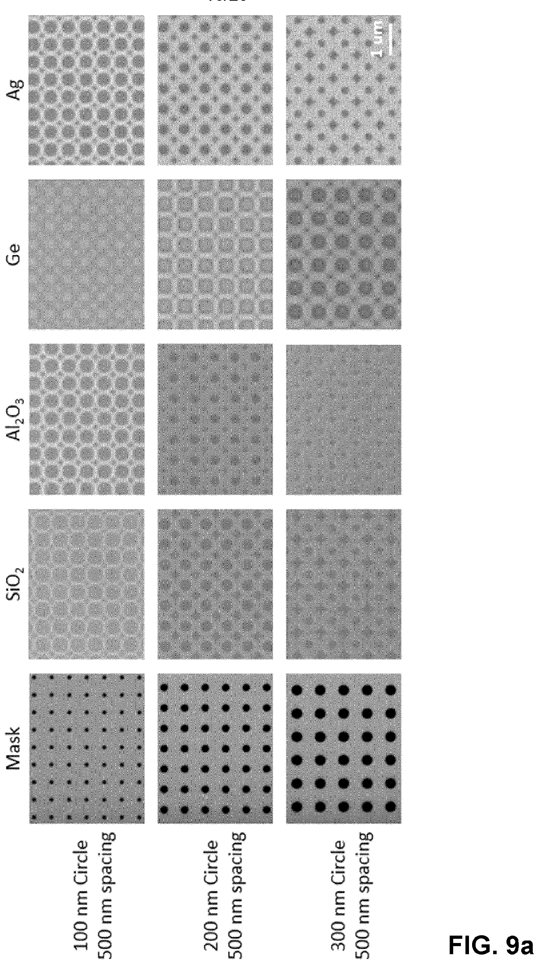

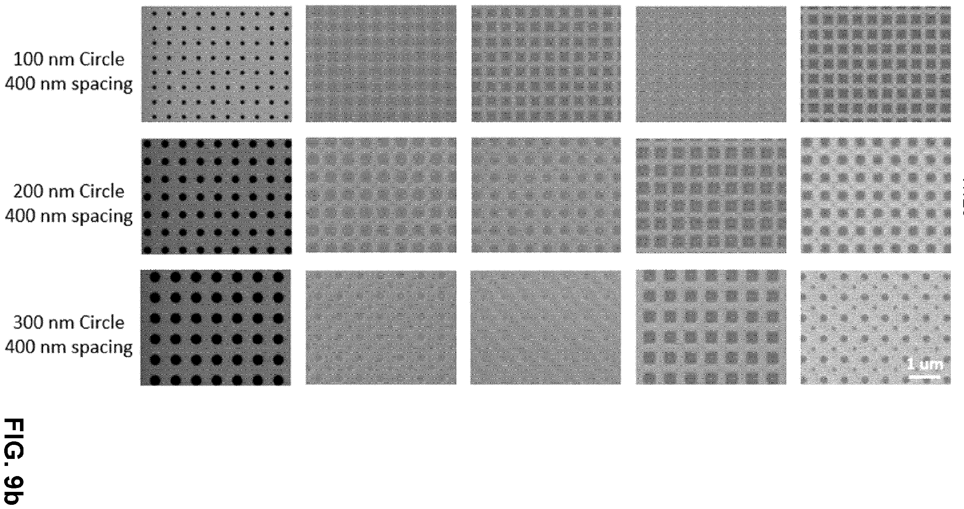

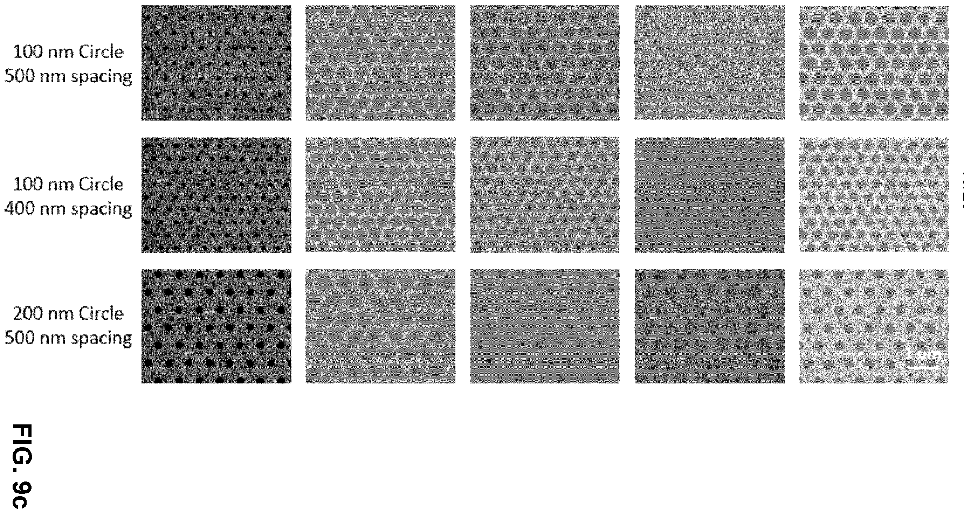

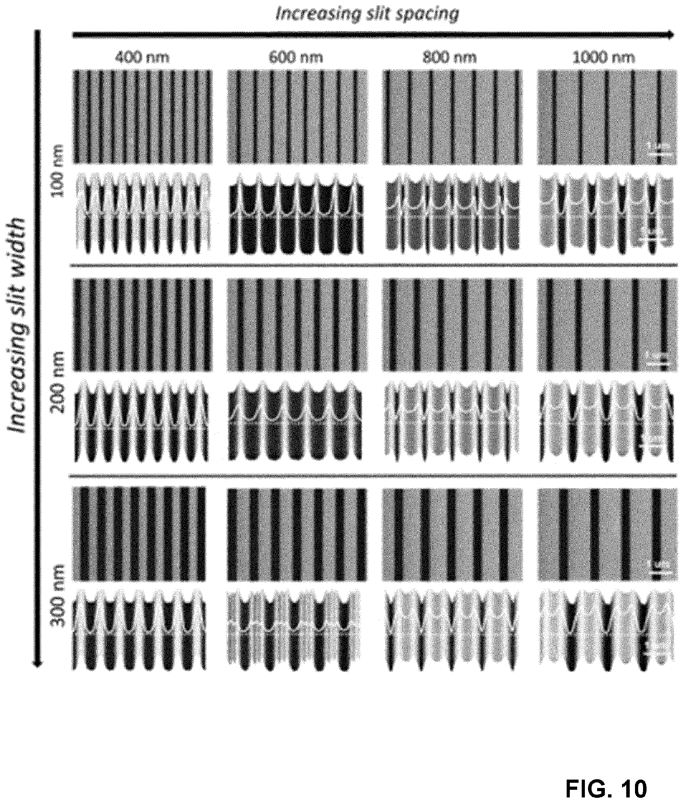

Figure 4a demonstrates AFM scans for a variety of 3D Ge deposition structures on a silicon substrate 2 achieved through MBHL deposition with varying aperture diameters, here called mask pore diameter, (100 nm to 300 nm) and spacings (200 nm to 500 nm). Two predominant features can be observed in these depositions: i) wall-like compartments arising from the vacant interference beneath the apertures 5, 5a, ... (*e.g.* Ge sample with a mask aperture diameter of 200 nm and an aperture spacing of 400 nm), ii) pillar-like structures that emerge from the constructive interference (*e.g.* Ge sample with an aperture diameter of 300 nm and an aperture spacing of 200 nm). Notably, some deposited nanostructures display a transitional geometry between these two distinct features (*e.g.* Ge sample with an aperture diameter of 100 nm and an aperture spacing of 500 nm), forming higher-order 3D nanostructures. More types of deposited patterns from various materials 6, 6a, ... and mask design are given in Figures 9 and 10.

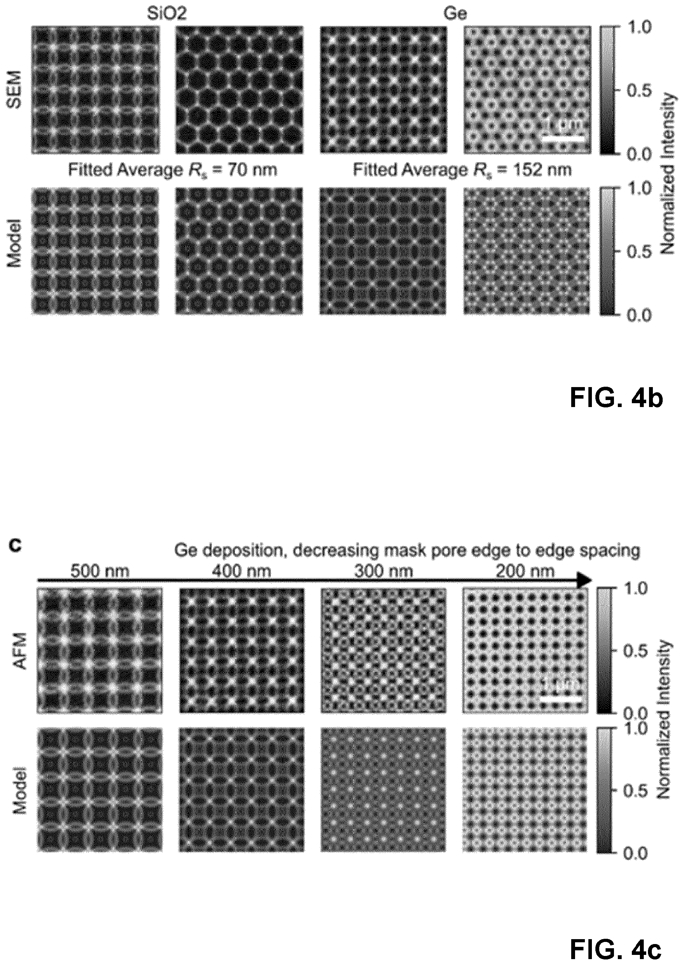

In practical experimental setups for MBHL, the geometry of the deposited nanostructures 1 is also influenced by the surface diffusion length, Rs, as depicted in Figure 1a. It is reasonable to consider that Rs comprises both a directional drift component, Rd, and a nondirectional diffusion component, Rf, such that $R_s = R_d + R_f = N(R_d, \sigma_f)$, where $N$ is the normal distribution function, and $\sigma_f$ is the variance of $R_f$. The directional drift, $R_d$, originates from the conservation of lateral momentum of the incident particles upon contact with the surface[17]. When particle-surface interactions are weaker, an incident particle tends to drift further before becoming immobilized by surface sites or defects[18], resulting in a larger value of $R_d$. The precision MBHL strongly depends on the reproducibility of $R_d$ on different surface conditions. By fitting the diameters of deposited ring patterns from various materials 6, 6a, ... at different substrate tilting angles φ (Figure 6a), we find that $R_s$ is a material-dependent property, while largely independent of the experimental setup's geometry and the incident trajectory. On a silicon substrate 2, the ranking of $R_s$ for various materials 6, 6a, ... is as follows: Au ≈ Ge > $SiO_2$ > $Al_2O_3$ ≈ Ag (see Figure 8). Incorporating the effect of surface diffusion into our model, we successfully reproduce the 3D morphology of nanostructures as measured by AFM. This is clearly demonstrated in the side-by-side comparisons for $SiO_2$ and Ge samples deposited using square- or hexagonal-lattice masks 4 with 100 nm nanopores with a spacing of 400 nm, as shown in Figure 4b, and for Ge samples deposited using square-lattice masks 4 with varied pore spacing, depicted in Figure 4c. In particular, figure 4c depicts a comparison of simulation results based on the computer-implemented method according to the invention (lower images) and measured AFM images for Ge deposition through 100 nm nanopores with different spacings ranging from 500 nm to 200 nm (upper images).

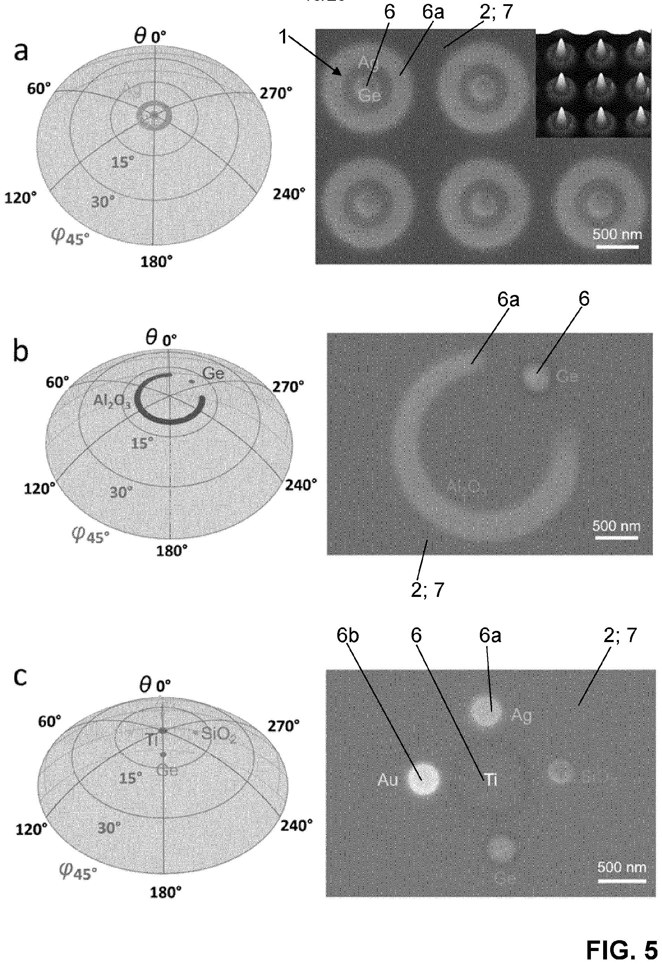

Beyond the nanopatterning of single materials 6, MBHL also enables nanopatterning of multiple materials 6, 6a, ... with precise alignment by making use of its self-alignment capability. Figure 5 exemplifies three kinds of combinations of binary up to quintenary materials 6, 6a, ... simply by varying substrate tilting angle φ and depositor rotating angle θ. All the materials 6, 6a, ... in the same figures are prepared in a single run and deposited in sequence. The left panels in Figure 5(a, b and c) give the experimental conditions of φ and θ, while the right panels present the corresponding generated nanopatterns and different materials 6, 6a, ... are rendered in different grey scales. By modifying φ and θ, the position that the deposited material 6, 6a, ... lands on the substrate 2 and the geometry that the pattern forms can be well controlled. Different geometries including dots, open rings, and rings can be obtained.

In particular, figure 5a depicts Ag being evaporated in a tilting angle φ of 5° for both the substrate 2 and the mask 4 with respect to the depositor 3 and wherein the substrate 2 and the mask 4 rotate at the same speed during the evaporation. Ge is evaporated without tilting. Given the self-alignment property with such a deposition process, binary nanostructures composed of ring-shape Ag and conic-shape Ge landing in the middle of the ring are formed. The inset shows AFM images of the binary nanostructures. Figure 5b depicts an evaporation of Al2O3 in a tilting angle φ of 10° for both the substrate 2 and the mask 4 with respect to the depositor 3 and the substrate 2 and the mask 4 rotate for 270° in total during the evaporation with respect to the depositor 3. Ge is evaporated in the same tilting angle φ but rotates to 315° offset. Meanwhile, the substrate 2 is kept stationary. As a result, binary nanostructures composed of open-ring-shape $Al_2O_3$ and dot-like material Ge landing in the ring opening position are formed. Figure 5c depicts an evaporation of Ti in a tilting angle φ of 0.5° for both the substrate 2 and the mask 4 with respect to the depositor 3 and the substrate 2 and the mask 4 rotate during the evaporation. Ag, $SiO_2$, Ge and Au are evaporated in a tilting angle φ of 10° for both the substrate 2 and the mask 4 with respect to the depositor 3 and the substrate 2 keeps stationary, but for each material 6, 6a, ... rotates to 90°, 180°, 270° offset with respect to the position of Ag in sequence. As a result, quintenary deposition structures composed of 5 different materials 6, 6a, ... are formed.

Figure 6 is a characterization of the influence of the gap or distance H between the mask 4 and substrate 2 as well as of the tilting angle φ of the substrate 2 and the mask 4 with respect to the depositor 3 on MBHL. In particular, figure 6a depicts SEM images of the deposited Ge patterns. Ge is evaporated in a tilting angle φ of 5° and the deposition thickness is 100 nm. In the depicted examples, the mask 4 is a $SiN_x$ mask having apertures 5, 5a, ... in various diameters ranging from 100 nm to 300 nm with a spacing of 1 μm. When the gap between the mask 4 and the substrate 2 increases from 0 μm to 2.5 μm, the deposited pattern changes from dot-shape into ring-shape and the ring width increases as the gap increases. Figure 6b depicts Ge being evaporated with a defined gap of 2.5 μm between the mask 4 and substrate 2. The deposition thickness is 100 nm. As the tilting angle φ increases, the ring width increases correspondingly. Figure 6c depicts AFM images of deposited Ge patterns from evaporation through apertures 5, 5a, ... with various diameters. Ge is evaporated in a tilting angle $\varphi$ of 5° and the deposition thickness is 100 nm. The mask-substrate gap or distance H changes from 0 to 2.5 $\mu$m.

Figure 7 is a characterization of the influence of mask design and tilting angle $\varphi$ of the substrate 2 and the mask 4 with respect to the depositor 3 on MBHL. Au is evaporated in various tilting angles $\varphi$ and the deposition thickness is 100 nm. The gap between the mask 4 and substrate 2 is 2.5 $\mu$m. The deposition thickness is 100 nm. Diverse deposition structures are formed while varying the mask design and tilting angle $\varphi$.

Figure 8 illustrates the influence of the material property on the properties of the deposition structures, here in the form of deposited rings. In particular, figure 8a depicts deposited rings that are fitted by two circles with different radii. The ring radius R and ring width w are defined as the average and the difference of the radii of the inner and outer circles, respectively. Figure 8b depicts SEM images of deposited rings from various materials 6, 6a, ... evaporated with a thickness of 100 nm and a tilting angle $\varphi$ of the substrate 2 and the mask 4 with respect to the depositor 3 of 5°. The mask-substrate gap is 2.5 $\mu$m. Figure 8c illustrates the dependence of extracted ring radius R from different materials 6, 6a, ... on the mask pore diameters. Figure 8d illustrates the dependence of extracted ring width w from different materials 6, 6a, ... on the mask pore diameters.

Figure 9 depicts an SEM characterization of deposition structures from various materials 6, 6a, ... through masks 4 with different aperture pattern designs. All the materials 6, 6a, ... are evaporated with a thickness of 100 nm and a tilting angle $\varphi$ of the substrate 2 and the mask 4 with respect to the depositor 3 of 5°. The mask-substrate gap is 2.5 $\mu$m. Figure 9a depicts $SiN_x$ masks 4 having the design of apertures 5, 5a, ... in the form of nanopores in various diameters ranging from 100 nm to 300 nm with a spacing of 500 nm arranged square configuration. Figure 9b depicts $SiN_x$ masks 4 having the design of apertures 5, 5a, ... in the form of nanopores in various diameters ranging from 100 nm to 300 nm with a spacing of 400 nm arranged in a square configuration. Figure 9c depicts $SiN_x$ masks 4 having the design of apertures 5, 5a, ... in the form of nanopores in 100 nm or 200 nm diameter with a spacing of 400 nm or 500 nm, arranged hexagonal configuration.

Figure 10 depicts an SEM characterization of deposition structures from various materials through masks 4 having apertures 5, 5a, ... in the form of different lines or slits. All the materials 6, 6a, ... are evaporated with a thickness of 100 nm and a tilting angle $\varphi$ of the substrate 2 and the mask 4 with respect to the depositor 3 of 5°. The mask-substrate gap is 2.5 $\mu$m. The $SiN_x$ masks 4 have the design of lines in various widths ranging from 100 nm to 300 nm with a spacing from 400 nm to 1000 $\mu$m.

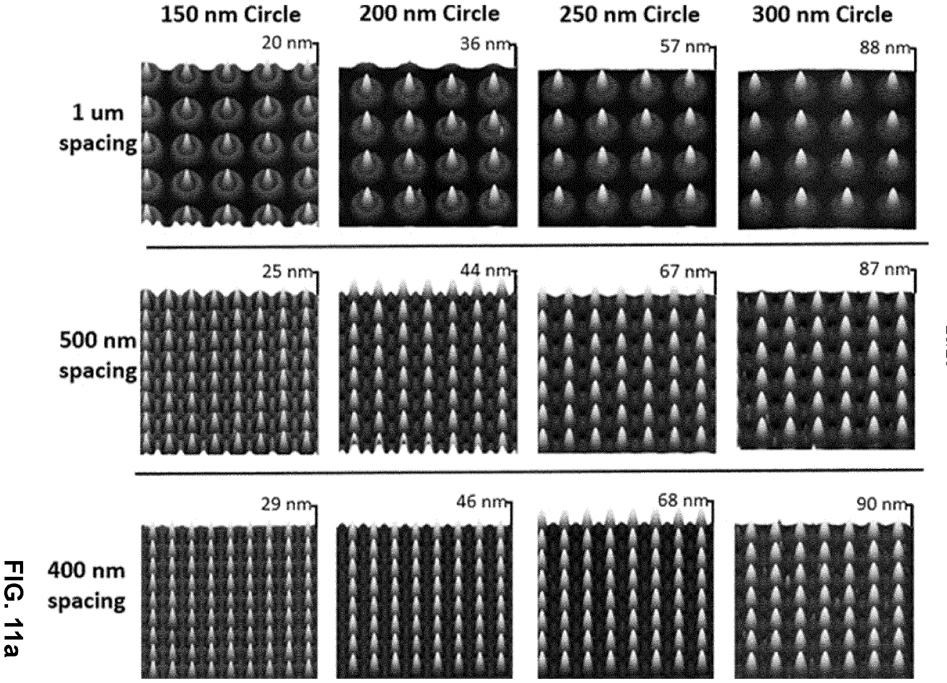

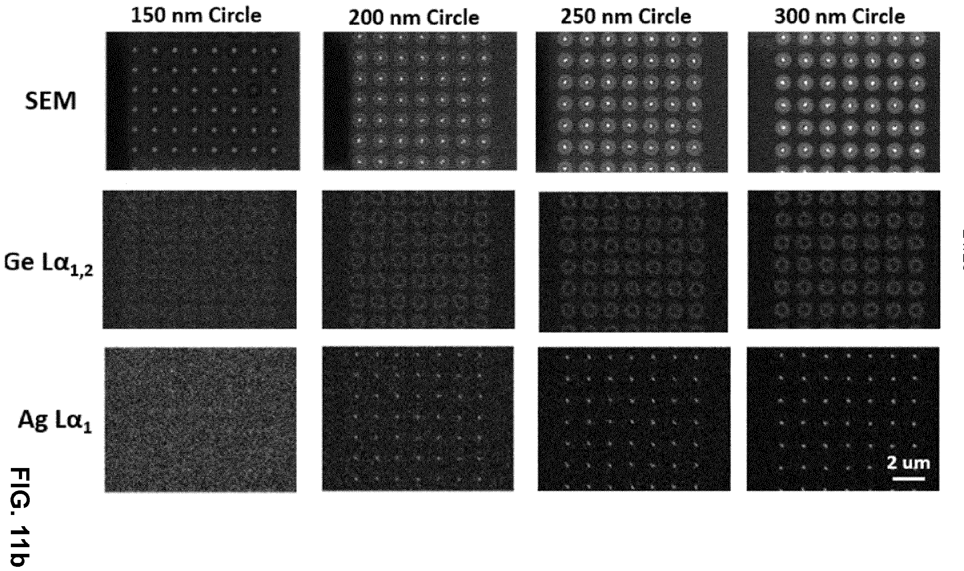

Figure 11 shows more results of the binary structures in Figure 5a and the energy dispersive X-ray (EDX) mapping confirms the distribution of Ag and Ge. In particular, figure 11 depicts a characterization of deposited binary deposition structures combing Ag and Ge. Ag is evaporated in a tilting angle $\varphi$ of the substrate 2 and the mask 4 with respect to the depositor 3 of 5° and the substrate 2 rotates during the evaporation. Ge is evaporated without tilting. Figure 11a depicts AFM images of deposited binary deposition structures 1 by varying the mask design. The mask pore diameters, *i.e.* apertures 5, 5a, ..., vary from 150 nm to 300 nm with a spacing of 50 nm. The mask pore spacings change from 400 nm, 500 nm to 1 $\mu$m. Figure 11b depicts an EDX mapping of the deposition structures 1 to confirm the existence of different materials, Ag and Ge. The mask pore spacing is 1 $\mu$m.

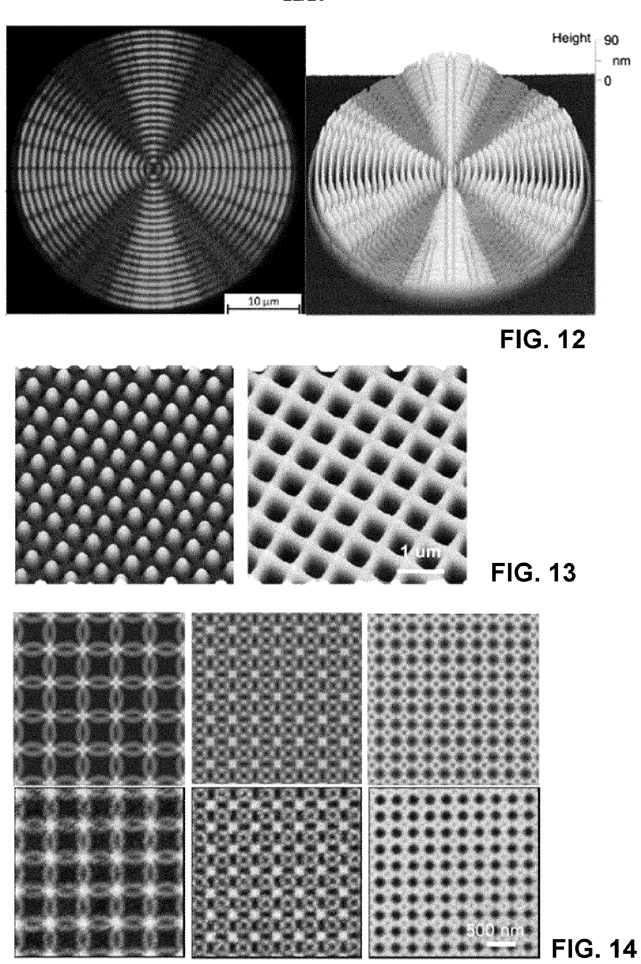

Figure 12 depicts a complex deposition structure 1 comprising solvent-sensitive material, Ir(ppy)$_3$ doped in CBP, a phosphorescent organic semiconductor. In particular, the left image of figure 12 depicts a fluorescent micrograph, and the right image depicts the corresponding tilted topography image resolved by AFM.

Figure 13 depicts AFM images showing positive-tone (left) and negative-tone (right) deposition structures 1 formed by using the same aperture membrane 4 but with different $\theta$-$\varphi$ trajectories. The right image is a standard waffle pattern.

Figure 14 depicts a comparison of complex deposition structures 1 predicted by the computer-implemented method according to the invention (top images) and AFM images of actually fabricated deposition structures 1 (bottom images).

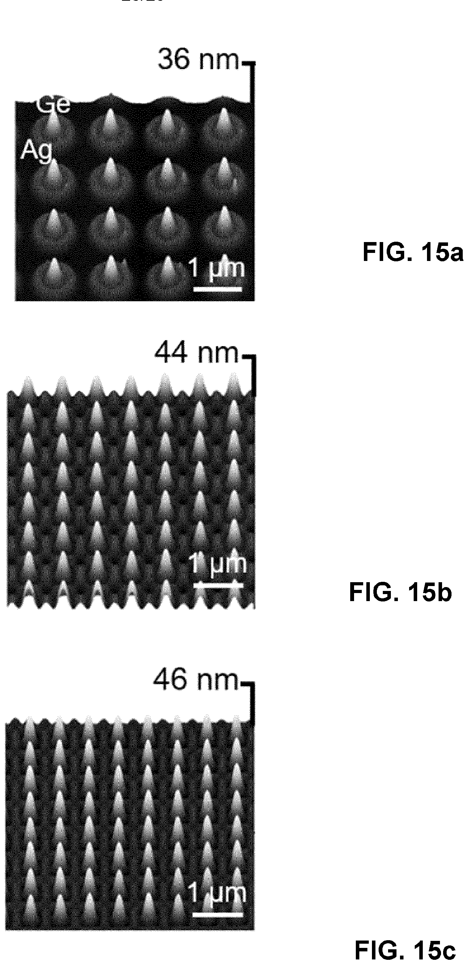

Figure 15 depicts AFM images showing the self-aligned deposition structures 1 containing germanium (Ge) tips surrounded by silver (Ag) rings/walls, in which the tips are accurately positioned at the center of rings/walls resulting from the self-aligned nature. Both materials 6, 6a are patterned by using the same aperture membrane but with different $\theta$-$\varphi$ trajectories.

*Section S1*

Figure 3a, lower image, shows part of the geometry of the MBHL setup viewed from the top. For a position $\boldsymbol{x}$ = (x, y) on the substrate 2, an exposure event characterized by parameters (D, $\varphi$, $\theta$) corresponds to an incident particle at position $\boldsymbol{x}_m = (x_m, y_m) = \boldsymbol{x}\text{-}\boldsymbol{u}$ on the mask plane. The vector $\boldsymbol{u}$ has a length R = $R_m + R_i + R_s$ = Dtan$\varphi$ + Rs, and an angle - $\theta$. We note this relation assumes that $R_s$ is independent of other parameters, which holds for our experimental conditions. The collection of all possible incident positions $\boldsymbol{x}_m$ forms the filter pattern **F**. However, a particle can only pass through a point $\boldsymbol{x}_m$ if such point resides within the domain of nanopores $\Omega$.

The mask pattern is represented by a continuous function M(**x**) where x is a two-dimensional position:

$$M(\mathbf{x}) = \begin{cases} 1, & \mathbf{x} \in \Omega \\ 0, & \mathbf{x} \notin \Omega \end{cases} \qquad (S1)$$

On the other hand, F(**u**) is a continuous function describing the probability that $\mathbf{x}_m$=x-u belongs to the filter pattern **F** for any x.

Assuming a uniform material flux $\Phi_0$ without any mask or stencil, the material flux at point x can be expressed as:

$$\Phi(\mathbf{x}) = \iint_{-\infty}^{\infty} \Phi_0 F(\mathbf{u}) M(\mathbf{x} - \mathbf{u}) w(\mathbf{u}) \, d\mathbf{u} \qquad (S2)$$

where w(**u**) represents the weight for each exposure event associated with vector **u**. For operations at uniform speed, w(**u**) =1. The deposition probability P(x, y)=P(**x**), is defined as the ratio between $\Phi(\mathbf{x})$ and $\Phi_0$, which follows:

$$P(\mathbf{x}) = \iint_{-\infty}^{\infty} F(\mathbf{u}) M(\mathbf{x} - \mathbf{u}) \, d\mathbf{u} \qquad (S3)$$

Eq. S3 reveals that the deposition is essentially a convolution operation between the filter pattern and the mask pattern. When F(**u**) and M(**x**) are represented using discrete matrices, F and M, respectively, the resulting probability matrix P can be written as **P** = Conv(**F**, **M**), which is Eq. (1) presented earlier.

In the computational model, **F** and **M** are matrices for 2D grid meshes with grid spacing h.

*Section S2*

Herein below, the derivation of Eq. (2) presented earlier is discussed.

The analytical solution for $P_c$ considering the simplified geometry in Figure 3b is derived in this section. Detailed trigonometric relationships between neighboring nanopores are shown in Figure 3b, lower image. The length of an intersecting arc, $C_i$ is determined by the central angle $\alpha_i$ and radius R of the filter pattern, such that $C_i = \alpha_i R$. Due to symmetry, there are Ni equivalent arcs intersecting with the i-th nearest aperture. $P_c$ can thus be expressed as the ratio of the total length of all intersecting arcs to the circumference of the filter ring:

$$P_c = \begin{cases} \dfrac{\sum_{i=1}^{\infty} N_i C_i}{2\pi R} = \dfrac{\sum_{i=1}^{\infty} N_i \alpha_i}{2\pi}, & \dfrac{R}{r} > 1 \\ \\ 1, & 0 < \dfrac{R}{r} \le 1 \end{cases} \qquad (S4)$$

The value of $\alpha_i$ for an intersecting arc is calculated using the law of cosines for the triangle formed by R, r and $L_i$ (Figure 3a, lower image):

$$r^2 = R^2 + L_i^2 - 2RL_i \cos\frac{\alpha}{2} \qquad (S5)$$

Rearranging Eq. S5 with dimensionless variables R/r and $L_i$/r gives:

$$\alpha_i = 2\cos^{-1}\left[\frac{\left(\dfrac{R}{r}\right)^2 + \left(\dfrac{L_i}{r}\right)^2 - 1}{2\dfrac{R}{r}\dfrac{L_i}{r}}\right] \qquad (S6)$$

When the filter ring does not intersect with i-th NNs, $\alpha_i$ becomes purely imaginary. We can thus generalize Eq. S4 as:

$$P_c = \sum_{i=1}^{\infty} \frac{N_i}{\pi} \operatorname{Re} \left\{ \cos^{-1} \left[ \frac{\left(\frac{R}{r}\right)^2 + \left(\frac{L_i}{r}\right)^2 - 1}{2\frac{R}{r}\frac{L_i}{r}} \right] \right\} + \varkappa(r - R) \qquad (S7)$$

where $\varkappa$ is the Heaviside step function, corresponding to Eq. 2 presented earlier.

The number of equivalent i-th NNs, $N_i$, is defined as the number of neighboring apertures 5, 5a, ... with the same center-to-center length $L_i$. For 2D square and hexagonal lattices, the values for $L_i$ are:

$$L_i = \begin{cases} L \cdot \sqrt{h^2 + k^2}, \text{ for square lattice} \\ L \cdot \sqrt{\left(h + \frac{1}{2}k\right)^2 + \left(\frac{\sqrt{3}}{2}k\right)^2}, \text{ for hexagonal lattice} \end{cases} \qquad (S8)$$

where h and k are integers (0, $\pm 1$, $\pm 2$, ...). The first few positive $L_i$ values for a square lattice are $\{L, \sqrt{2}L, 2L, \sqrt{5}L, 2\sqrt{2}L, ...\}$, while those for a hexagonal lattice become $\{L, \sqrt{3}L, 2L, \sqrt{7}L, 3L, ...\}$. The centers of the constructive regimes in Figure 3c occur when the arcs pass through the center of the i-th NNs, explaining why they align with straight lines having R/L values in the series of $L_i$.

*Material and methods*

For illustrative purposes only, manufacturing examples for the mask 4 and the substrate 2 are given below.

*Mask fabrication*

$SiN_x$ masks 4 were fabricated on 4-inch silicon wafers with a 50nm-thick low stress $SiN_x$ layer on both sides deposited by low-pressure chemical vapor deposition. Firstly, apertures 5, 5a, ..., respectively, were patterned in the $SiN_x$ layer on the front side of the wafer by electron beam lithography (EBPG5200, Raith) and followed with reactive ion etching (PlasmaPro 80 RIE, Oxford Instruments). Windows were then opened on the backside of the wafer by conventional UV lithography (EVG 620 NT, EV Group) with alignment to the apertures 5, 5a, ... on the front side. The bulk silicon was etched through the opened windows by deep reactive ion etching (SPTS) and KOH wet etching to release the membranes on the front side. After membrane release, the wafers were cleaved into 1 cm$\times$ 1 cm chips for the nanopatterning process.

*Substrate preparation*

Substrates 2 with spacer elements were prepared using UV lithography. A bare silicon wafer was first cleaned with acetone and isopropanol in sequence. Then the photoresist was spun coated at 4000 rpm and baked on a hot plate at 110 °C for 2 min. Different spacer element heights were defined using different photoresist. In specific, AZ1505 and AZ1518 (MicroChemicals) were used to define 0.7 $\mu$m and 2.5 $\mu$m spacer element height separately. After exposure and development, the wafer was cleaved into 2 cm $\times$ 2 cm chips for the deposition process.

*Deposition conditions and characterization*

Different materials 6, 6a, ... were evaporated in a commercial electron beam evaporation system (MEB 550S, Plassys) at <5$\times$10-7 mBar. Scanning electron microscopy (SEM) images were acquired using a field emission microscope (Ultra plus, Zeiss). Electron dispersive X-ray (EDX) mapping results were obtained using a Zeiss Ultra 55 equipped with a Ultim Max detector (Oxford Instruments). Atomic force microscopy (AFM) images were carried out on NX20 (Park Systems) in non-contact mode.

*Numerical simulations*

The numerical simulations of the MBHL deposition process were conducted using the Python mbhl package, available at https://github.com/alchem0x2A/nanolitho, which is distributed under the MIT license.

*Conclusion*

We have demonstrated a direct 3D deposition method that is based on the interaction of beams of material 6, 6a, .... Diverse deposition structures 1 even in the nanometer-range from various materials 6, 6a, ... were generated. MBHL displayed unique self-alignment capability compared with conventional lithographic methods. A computer-implemented method of determining operation parameters for producing a deposition structure 1 is introduced to simulate the generated deposition structures 1 and meanwhile guide the deposition process. The experimental results were well-matched with the simulated deposition structures 1. This technique is capable of generating intricate nanopatterns and its self-alignment capability allows for OLED nanopatterning of multiple colors, for instance. The deposition process according to the invention is scalable, low-cost, and high-throughput without solvent processing. Moreover, the present invention allows the creation of wavy and other three-dimensional complex deposition structures 1 made by solvent-sensitive materials 6, 6a, ..., such as organic semiconductors. In addition, the method allows the creation of both positive- and negative-tone patterns using the same mask 4, by using different degrees of material beam interference. Furthermore, a nanoscale precision can be achieved without expensive optics with considerably reduced equipment cost.

*References*

1. Liu, S. et al. Nanopatterning Technologies of 2D Materials for Integrated Electronic and Optoelectronic Devices. Adv. Mater. 34, 2200734 (2022).

2. Lassaline, N. et al. Optical Fourier surfaces. Nature 582, 506-510 (2020).

3. Dvir, T., Timko, B. P., Kohane, D. S. & Langer, R. Nanotechnological strategies for engineering complex tissues. Nat. Nanotechnol. 6, 13-22 (2011).

4. Jeong, J. W. et al. High-resolution nanotransfer printing applicable to diverse surfaces via interface-targeted adhesion switching. Nat. Commun. 5, 5387 (2014).

5. Vazquez-Mena, O., Gross, L., Xie, S., Villanueva, L. G. & Brugger, J. Resistless nanofabrication by stencil lithography: A review. Microelectron. Eng. 132, 236-254 (2015).

6. Vazquez-Mena, O. et al. High-Resolution Resistless Nanopatterning on Polymer and Flexible Substrates for Plasmonic Biosensing Using Stencil Masks. ACS Nano 6, 5474-5481 (2012).

7. Zaumseil, J. et al. Three-Dimensional and Multilayer Nanostructures Formed by Nanotransfer Printing. Nano Lett. 3, 1223-1227 (2003).

8. Loo, Y.-L., Willett, R. L., Baldwin, K. W. & Rogers, J. A. Interfacial Chemistries for Nanoscale Transfer Printing. J. Am. Chem. Soc. 124, 7654-7655 (2002).

9. Jung, W. et al. Three-dimensional nanoprinting via charged aerosol jets. Nature 592, 54-59 (2021).

10. Deshmukh, M. M., Ralph, D. C., Thomas, M. & Silcox, J. Nanofabrication using a stencil mask. Appl. Phys. Lett. 75, 1631-1633 (1999).

11. Lu, C. & Lipson, R. h. Interference lithography: a powerful tool for fabricating periodic structures. Laser Photonics Rev. 4, 568-580 (2010).

12. Yang, X., Yao, J., Rho, J., Yin, X. & Zhang, X. Experimental realization of three-dimensional indefinite cavities at the nanoscale with anomalous scaling laws. Nat. Photonics 6, 450-454 (2012).

13. Poddubny, A., Iorsh, I., Belov, P. & Kivshar, Y. Hyperbolic metamaterials. Nat. Photonics 7, 948-957 (2013).

14. Huang, M. et al. Reusable Nanostencils for Creating Multiple Biofunctional Molecular Nanopatterns on Polymer Substrate. Nano Lett. 12, 4817-4822 (2012).

15. Vazquez-Mena, O., Sannomiya, T., Villanueva, L. G., Voros, J. & Brugger, J. Metallic Nanodot Arrays by Stencil Lithography for Plasmonic Biosensing Applications. ACS Nano 5, 844-853 (2011).

16. Yamamoto, H. et al. Nanoscale Organic Light-Emitting Diodes. Nano Lett. 5, 2485-2488 (2005).

17. Abelmann, L. & Lodder, C. Oblique evaporation and surface diffusion. Thin Solid Films 305, 1-21 (1997).

18. Kleyn, A. W. Chapter 2 Basic Mechanisms in Atom-Surface Interactions. in Handbook of Surface Science (eds. Hasselbrink, E. & Lundqvist, B. I.) vol. 3 29-52 (North-Holland, 2008).

LIST OF REFERENCE SIGNS

| | |
|---|---|
| 1 | deposition structure |
| 2 | substrate |
| 3 | depositor |

**EP 4 671 406 A1**

| 4 | mask |
|---|---|
| 5, 5a, ... | aperture |
| 6, 6a | material |
| 7 | surface |
| 8 | spacer element |
| 100 | depositor arrangement |
| $\theta$ | rotating angle |
| $\varphi$ | tilting angle |
| R | spreading distance |
| Rm | distance from mask edge |
| Ri | incidence shift caused by tilting |
| Rs | surface diffusion distance |
| As | rotation axis substrate |
| Am | rotation axis mask |
| Ts | tilting axis substrate |
| Tm | tilting axis mask |
| H | distance |

**Claims**

1. A method of producing a deposition structure (1) on a substrate (2) comprising the steps of:

   - Providing at least one depositor (3) for depositing at least one material (6);
   - Providing at least one mask (4) comprising a plurality of apertures (5, 5a, ...);
   - Providing at least one substrate (2); and
   - Depositing at least one material (6) from the depositor (3),

   wherein part of the material (6) passes through the apertures (5, 5a, ...) of the mask (4) and is deposited on a surface (7) of the substrate (2), whereby at least one deposition structure (1) is formed on the surface (7) of the substrate (2),
   **characterized in that** at least one tilting angle ($\varphi$) between i) the substrate (2) and/or the mask (4) and ii) the depositor (3) is at least temporarily changed before and/or during the deposition of the material (6), and/or **in that** at least one rotating angle ($\theta$) between i) the substrate (2) and/or the mask (4) and ii) the depositor (3) is at least temporarily changed before and/or during the deposition of the material (6).

2. The method according to claim 1, wherein the substrate (2) and/or the mask (4) is at least temporarily tilted and/or rotated such:

   - that the deposition structure (1) comprises or consists of material (6) being deposited on the surface (7) at a given position on the surface (7) that is provided from two or more beams of material (6) passing through at least one aperture (5, 5a, ...) of the mask (4) at different moments in time, and/or
   - that the deposition structure (1) comprises or consists of material (6) being deposited on the surface (7) at a given position on the surface (7) that is spatially displaced with respect to a reference-incidence position of said material (6) normal to the surface (7) of the substrate (2).

3. The method according to any one of the preceding claims, wherein the substrate (2) and/or the mask (4) is at least temporarily tilted and/or rotated such:

   - that two or more beams of material (6) are interfering with one another, and/or
   - that an amount of material (6) deposited at specific positions on the surface (7) of the substrate (2) is modulated.

4. The method according to any one of the preceding claims, wherein at least one of:

   - the substrate (2) and/or the mask (4) is at least temporarily rotated while being tilted during the deposition of the material (6),
   - the tilting angle ($\varphi$) is changed or kept constant during the deposition,

- the rotating angle (θ) is changed or kept constant during the deposition, or
- the rotating angle (θ) and the tilting angle (φ) are the same or different from one another.

5. The method according to any one of the preceding claims, wherein the substrate (2) is rotated about a rotation axis (As) that runs centrally through the substrate (2) and/or wherein the mask (4) is rotated about a rotation axis (Am) that runs centrally through the mask (4), and/or

wherein the substrate (2) is tilted about a tilting axis (Ts) that runs centrally through the substrate (2) and/or wherein the mask (4) is tilted about a tilting axis (Tm) that runs centrally through the mask (4), and wherein the rotation axis (As; Am) of the substrate (2) and/or the mask (4) and the tilting axis (Ts; Tm) of the substrate (2) and/or the mask (4) preferably run parallel to one another.

6. The method according to any one of the preceding claims, wherein at least one of:

- the depositor (3) is kept stationary during deposition, or
- the mask (4) and the substrate (2) are arranged at a distance (H) from one another, the distance (H) preferably being kept constant during the deposition.

7. The method according to any one of the preceding claims, wherein a shape of the apertures (5, 5a, ...) is the same or different from one another, and/or

wherein a clear width of the apertures (5, 5a, ...) is the same or different from one another, and/or
wherein the apertures (5, 5a, ...) are arranged in a pattern, for instance in a square pattern or a hexagonal pattern or a bullseye pattern, and/or
wherein an edge-to-edge spacing between neighbouring apertures (5, 5a, ...) is the same or different from one another.

8. The method according to any one of the preceding claims, wherein the deposition structure (1) is a nanostructure, in particular a three-dimensional nanostructure, and/or
wherein the deposition structure (1) has a spatial extension along at least one and preferably along three spatial directions being in the nanometer range.

9. The method according to any one of the preceding claims, wherein the material (6) comprises or consists of one or more metals or metal compounds, one or more oxides such as metal oxides, one or more organic molecules, or mixtures thereof, and/or

wherein the material (6) is air-sensitive and/or liquid-sensitive, and/or
wherein the material (6) is directly deposited and/or deposited under dry conditions, in particular in the absence of any resists and solvents.

10. The method according to any one of the preceding claims, wherein at least a further material (6a) is deposited, and wherein the substrate (2) and/or the mask (4) are tilted before and/or during the deposition of the further material (6a) such, that:

- an interference of two or more beams of the further material (6a) is different from an interference between two or more beams of the material (6), and/or
- a modulation of an amount of further material (6a) deposited at specific positions on the surface (7) of the substrate (2) and/or on the material (6) deposited on the surface (7) of the substrate (2) is different from a modulation of an amount of the material (6) deposited at specific positions on the surface (7) of the substrate (2), and/or
- a spatial displacement of the further material (6a) being deposited on the surface (7) of the substrate (2) and/or the material (6) deposited on the surface (7) of the substrate (2) with respect to a reference-incidence position of said further material (6a) normal to the surface (7) of the substrate (2) is different from a spatial displacement of the material (6) with respect to a reference-incidence position of said material (6) normal to the surface (7) of the substrate (2).

11. The method according to any one of the preceding claims, wherein two or more materials (6, 6a) are deposited, and:

- wherein the two or more materials (6, 6a) are deposited in a single run and/or in sequence, and/or
- wherein the rotating angle ($\theta$) about which the substrate (2) and/or the mask (4) is rotated before and/or during the deposition of a first material (6) of the two or more materials (6, 6a) and a rotating angle ($\theta$) about which the substrate (2) and/or the mask (4) is rotated before and/or during the deposition of a second material (6a) of the two or more materials (6, 6a) is the same or different from one another, and/or
- wherein the tilting angle ($\varphi$) between i) the substrate (2) and/or the mask (4) and ii) the depositor (3) before and/or during the deposition of the first material (6) and a tilting angle ($\varphi$) between i) the substrate (2) and/or the mask (4) and ii) the depositor (3) before and/or during the deposition of the second material (6a) is the same or different from one another, and/or
- wherein the substrate (2) and/or the mask (4) is at least temporarily not rotated and/or not tilted during the deposition of the second material (6a).

12. A computer-implemented method of determining operation parameters for producing a deposition structure (1) on a substrate (2) as claimed in any one of the preceding claims, wherein the computer-implemented method comprises the steps of:

- Receiving, at a computing device, at least one mask pattern **M**, wherein the mask pattern **M** is preferably defined as a continuous function M(**x**), where **x**($x$, $y$) is a two-dimensional position and $\Omega$ is the domain of the plurality of apertures (5, 5a, ...) of the mask (4):

$$M(\mathbf{x}) = \begin{cases} 1, & x \in \Omega \\ 0, & x \notin \Omega \end{cases}$$

- Receiving, at the computing device, at least one filter pattern **F**, wherein the filter pattern **F** preferably is a projection of a trajectory (D, $\varphi$, $\theta$) onto the surface (7) of the substrate (2) for possible incident locations of the material (6) on the substrate (2), where D is the radius of a parametric hemisphere, $\varphi$ is the tilting angle ($\varphi$) and $\theta$ is the rotating angle ($\theta$);
- Generating, at the computing device, an output set of operation parameters corresponding to a morphology of the deposition structure (1) on the surface (7) of the pattern by determining a probability pattern from a convolution of the filter pattern F and the mask pattern M.

13. A non-transient computer readable medium being encoded with a computer program product comprising computer code that, when executed in a processor, cause the processor to perform the method of any one of claims 1 to 11 and/or of claim 12.

14. A depositor arrangement (100) comprising a depositor (3), a mask (4) and a substrate (2) as claimed in any one of claims 1 to 11, a processor, and the non-transient computer readable medium as claimed in claim 12.

15. Use of a deposition structure (1) as claimed in any one of claims 1 to 11 as a display device or as part thereof, preferably an OLED display, and/or as a metasurface for instance in an optical device.

**FIG. 1a**

FIG. 1b

FIG. 2a

FIG. 2b

FIG. 2c

**a**

Incident trajectory
$(D, \varphi, \theta)$ domain

$R \approx (H + \delta)\tan\varphi$

$D \approx H + \delta$

$\varphi$

$\theta$

Filter pattern **F**

Mask pattern **M**

4

5

5a

2

Deposition probability **P**

Constructive
interference

1

Vacant
interference

Top view

Incidence

F

$(x_m, y_m)$

$R_s + R_m + R_i$

$\Omega$

$\theta$

Mask

Substrate

**FIG. 3a**

**FIG. 3b**

FIG. 3c

FIG. 3d

FIG. 4a

FIG. 4b

FIG. 4c

**FIG. 5**

No gap       0.7 um gap       2.5 um gap

100 nm Circle

200 nm Circle

300 nm Circle

1 µm

2° tilt       5° tilt

100 nm Circle

200 nm Circle

300 nm Circle

1 um

FIG. 6a-b

FIG. 6c

FIG. 7

$$\text{Ring radius} \quad R = \frac{R_1 + R_2}{2}$$

$$\text{Ring width} \quad w = R_2 - R_1$$

FIG. 8a

FIG. 8b

FIG. 8c

FIG. 8d

FIG. 9a

FIG. 9b

FIG. 9c

FIG. 10

FIG. 11a

FIG. 11b

**FIG. 12**

**FIG. 13**

**FIG. 14**

FIG. 15a

FIG. 15b

FIG. 15c

Europäisches
Patentamt

European
Patent Office

Office européen
des brevets

# EUROPEAN SEARCH REPORT

**Application Number**

EP 24 18 5086

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2024/125833 A1 (UNIV COPENHAGEN [DK]) 20 June 2024 (2024-06-20) <br> * page 1, line 1 - line 3 * <br> * page 3, line 33 - line 35; figure 1 * <br> * page 5, line 22 - page 6, line 5 * <br> * page 11, line 16 - line 29; figures 8, 10 * <br> * page 13, line 4 - line 14 * <br> * page 15, line 5 - line 15; figure 14 * <br> ----- | 1-11, 13-15 | INV. <br> C23C14/04 <br> C23C14/22 <br> C23C14/52 <br> C23C14/54 <br> H01L21/308 <br> H05B33/10 <br> H10K71/16 <br> G03F9/00 <br> B82Y40/00 |
| X | CN 114 524 406 A (UNIV ZHEJIANG) 24 May 2022 (2022-05-24) <br> * See enclosed machine translation; figures 1, 4, 5 * <br> ----- | 1-11 | |
| A | EP 2 286 000 B1 (CONSIGLIO NAZIONALE RICERCHE [IT]) 29 June 2016 (2016-06-29) <br> * the whole document * <br> ----- | 1-15 | |
| A | SAMEH TAWFICK ET AL: "Engineering of Micro- and Nanostructured Surfaces with Anisotropic Geometries and Properties", ADVANCED MATERIALS, VCH PUBLISHERS, DE, vol. 24, no. 13, 6 March 2012 (2012-03-06) , pages 1628-1674, XP071811953, ISSN: 0935-9648, DOI: 10.1002/ADMA.201103796 * the whole document * <br> ----- | 1-15 | **TECHNICAL FIELDS SEARCHED (IPC)** <br><br> C23C <br> B82Y |

The present search report has been drawn up for all claims

| Place of search | Date of completion of the search | Examiner |
|---|---|---|
| The Hague | 26 March 2025 | Castagné, Caroline |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 5086

This annex lists the patent family members relating to the patent documents cited in the above-mentioned European search report.
The members are as contained in the European Patent Office EDP file on
The European Patent Office is in no way liable for these particulars which are merely given for the purpose of information.

26-03-2025

| Patent document cited in search report | | Publication date | Patent family member(s) | | Publication date |
|---|---|---|---|---|---|
| WO 2024125833 | A1 | 20-06-2024 | NONE | | |
| CN 114524406 | A | 24-05-2022 | NONE | | |
| EP 2286000 | B1 | 29-06-2016 | EP | 2286000 A1 | 23-02-2011 |
| | | | US | 2011303634 A1 | 15-12-2011 |
| | | | WO | 2009138960 A1 | 19-11-2009 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **LIU, S. et al.** Nanopatterning Technologies of 2D Materials for Integrated Electronic and Optoelectronic Devices. *Adv. Mater.*, 2022, vol. 34, 2200734
- **LASSALINE, N. et al.** Optical Fourier surfaces. *Nature*, 2020, vol. 582, 506-510
- **DVIR, T.** ; **TIMKO, B. P.** ; **KOHANE, D. S.** ; **LANGER, R.** Nanotechnological strategies for engineering complex tissues. *Nat. Nanotechnol.*, 2011, vol. 6, 13-22
- **JEONG, J. W. et al.** High-resolution nanotransfer printing applicable to diverse surfaces via interface-targeted adhesion switching. *Nat. Commun.*, 2014, vol. 5, 5387
- **VAZQUEZ-MENA, O.** ; **GROSS, L.** ; **XIE, S.** ; **VILLANUEVA, L. G.** ; **BRUGGER, J.** Resistless nanofabrication by stencil lithography: A review. *Microelectron. Eng.*, 2015, vol. 132, 236-254
- **VAZQUEZ-MENA, O. et al.** High-Resolution Resistless Nanopatterning on Polymer and Flexible Substrates for Plasmonic Biosensing Using Stencil Masks. *ACS Nano*, 2012, vol. 6, 5474-5481
- **ZAUMSEIL, J. et al.** Three-Dimensional and Multilayer Nanostructures Formed by Nanotransfer Printing. *Nano Lett.*, 2003, vol. 3, 1223-1227
- **LOO, Y.-L.** ; **WILLETT, R. L.** ; **BALDWIN, K. W.** ; **ROGERS, J. A.** Interfacial Chemistries for Nanoscale Transfer Printing. *J. Am. Chem. Soc.*, 2002, vol. 124, 7654-7655
- **JUNG, W. et al.** Three-dimensional nanoprinting via charged aerosol jets. *Nature*, 2021, vol. 592, 54-59

- **DESHMUKH, M. M.** ; **RALPH, D. C.** ; **THOMAS, M.** ; **SILCOX, J.** Nanofabrication using a stencil mask. *Appl. Phys. Lett.*, 1999, vol. 75, 1631-1633
- **LU, C.** ; **LIPSON, R. H.** Interference lithography: a powerful tool for fabricating periodic structures. *Laser Photonics Rev.*, 2010, vol. 4, 568-580
- **YANG, X.** ; **YAO, J.** ; **RHO, J.** ; **YIN, X.** ; **ZHANG, X.** Experimental realization of three-dimensional indefinite cavities at the nanoscale with anomalous scaling laws. *Nat. Photonics*, 2012, vol. 6, 450-454
- **PODDUBNY, A.** ; **LORSH, I.** ; **BELOV, P.** ; **KIVSHAR, Y.** Hyperbolic metamaterials. *Nat. Photonics*, 2013, vol. 7, 948-957
- **HUANG, M. et al.** Reusable Nanostencils for Creating Multiple Biofunctional Molecular Nanopatterns on Polymer Substrate. *Nano Lett.*, 2012, vol. 12, 4817-4822
- **VAZQUEZ-MENA, O.** ; **SANNOMIYA, T.** ; **VILLANUEVA, L. G.** ; **VOROS, J.** ; **BRUGGER, J.** Metallic Nanodot Arrays by Stencil Lithography for Plasmonic Biosensing Applications. *ACS Nano*, 2011, vol. 5, 844-853
- **YAMAMOTO, H. et al.** Nanoscale Organic Light-Emitting Diodes. *Nano Lett.*, 2005, vol. 5, 2485-2488
- **ABELMANN, L.** ; **LODDER, C.** Oblique evaporation and surface diffusion. *Thin Solid Films*, 1997, vol. 305, 1-21
- Basic Mechanisms in Atom-Surface Interactions. **KLEYN, A. W.** Handbook of Surface Science. 2008, vol. 3, 29-52